# EUROPEAN PATENT APPLICATION

(11) **EP 2 599 812 A1**
(43) Date of publication of application: **05.06.2013**
(21) Application number: 11812307.4
(22) Date of filing: 19.07.2011
(51) Int. Cl.: C08G 59/62, C08G 8/04, C08G 59/20, C08K 3/00, C08L 63/00, H01L 23/29, H01L 23/31

(54) **CURING RESIN COMPOSITION, CURED PRODUCT THEREOF, PHENOLIC RESIN, EPOXY RESIN, AND SEMICONDUCTOR SEALING MATERIAL**

(30) Priority: 30.07.2010 JP 2010172016
(71) Applicant: DIC Corporation, Tokyo 174-8520 (JP)
(72) Inventor: OGURA Ichirou, Ichihara-shi Chiba 290-8585 (JP); HIROTA Yousuke, Ichihara-shi Chiba 290-8585 (JP); TAKAHASHI Yoshiyuki, Ichihara-shi Chiba 290-8585 (JP); NAGAE Norio, Ichihara-shi Chiba 290-8585 (JP); NAKAMURA Nobuya, Ichihara-shi Chiba 290-8585 (JP)
(74) Representative: Albrecht, Thomas
(86) International application number: PCT/JP2011/066342
(87) International publication number: WO 2012/014715

(57) **Abstract**

The present invention provides a heat-curable resin composition having excellent fluidity and realizing moisture-resistance reliability suitable for recent electronic component-related materials and high flame retardancy in a halogen-free state for harmony with the environment, a cured product thereof, a semiconductor encapsulating material using the composition, and a phenol resin and epoxy resin which give these performances. The heat-curable resin composition includes, as essential components, an epoxy resin (A) and a phenol resin (B), the phenol resin (B) having a phenol resin structure having, as a basic skeleton, a structure in which a plurality of phenolic hydroxyl group-containing aromatic skeletons (ph) are bonded to each other through an alkylidene group or a methylene group having an aromatic hydrocarbon structure, and an aromatic nucleus of the phenol resin structure has a naphthylmethyl group or an anthrylmethyl group.

## Description

### Technical Field

The present invention relates to a heat-curable resin composition which produces a cured product having excellent heat resistance, moisture-resistance reliability, flame retardancy, dielectric characteristics, and curability in curing reaction and which can be preferably used for a semiconductor encapsulating material, a printed circuit board, a coating material, cast molding, etc., a cured product thereof, a phenol resin, an epoxy resin, and a semiconductor encapsulating material using the heat-curable resin composition.

### Background Art

Heat-curable resin compositions each containing an epoxy resin and a curing agent therefor as essential components are excellent in various physical properties such as high heat resistance, moisture resistance, low viscosity, and the like, and are thus widely used for electronic components such as a semiconductor encapsulating material, a printed circuit board, and the like; the electronic component field; conductive adhesives such as conductive paste; other adhesives; matrixes for composite materials; coating materials; photoresist materials; color developing materials; etc.

In these various applications, particularly, in application to advanced materials, performances such as heat resistance and moisture-resistance reliability have been recently required to be further improved. For example, in the semiconductor encapsulating material field, reflow treatment temperatures are increased due to transition to surface-mount packages, such as BGA and CSP packages, and response to lead-free solder, and thus encapsulation resin materials for electronic components, which have ever-more excellent moisture resistance and solder resistance, are desired.
Further, the movement toward exclusion of halogen-based flame retardants has been recently increased from the viewpoint of harmony with the environment, and thus epoxy resins and phenol resins (curing agent) which exhibit a high degree of flame retardancy in a halogen-free state have been required.

Examples of disclosed a phenol resin and an epoxy resin for electronic component encapsulating materials which comply with these requirements include a benzylated phenol resin produced by reaction of a phenol resin with a benzylating agent such as benzyl chloride and an epoxy resin produced by reaction of the benzylated phenol resin with epichlorohydrin (refer to, for example, Patent Literature 1), and a phenol resin produced by reaction of a phenol compound with dichloromethylnaphthalene and an epoxy resin produced by reaction of the phenol resin, which is produced by reaction with dichloromethylnaphthalene, with epichlorohydrin (refer to, for example, Patent Literatures 2 and 3) .

However, the epoxy resin and phenol resin disclosed in Patent Literature 1 are decreased in moisture-absorption characteristics and improved to some extent in moisture resistance and solder resistance, but these properties are unsatisfactory to the levels required in recent years. In addition, these resins are poor in flame retardancy and cannot be designed as halogen-free materials. In addition, the epoxy resin and phenol resin (curing agent) disclosed in Patent Literatures 2 and 3 have some degree of effect of improving flame retardancy but have high viscosity and thus have low fluidity during molding, thereby making it quite impossible to use for electronic components with recent finer pitches.

Accordingly, in the field of electronic component-related materials, it is the present situation that an epoxy resin composition satisfying fluidity, moisture-resistance reliability, and flame retardancy has not yet been found.

### Citation List

### Patent Literature

PTL 1: Japanese Unexamined Patent Application Publication No. 8-120039
PTL 2: Japanese Unexamined Patent Application Publication No. 2004-59792
PTL 3: Japanese Unexamined Patent Application Publication No. 2004-123859

### Summary of Invention

### Technical Problem

Accordingly, a problem to be solved by the present invention is to provide a heat-curable resin composition having excellent fluidity and realizing moisture-resistance reliability suitable for recent electronic component-related materials and high flame retardancy in a halogen-free state for harmony with the environment, a cured product thereof, a semiconductor encapsulating material using the composition, and a phenol resin and epoxy resin which give these performances.

### Solution to Problem

As a result of intensive research for solving the problem, the inventors of the present invention found that in a phenol resin having, as a basic skeleton, a structure in which a plurality of phenolic hydroxyl group-containing aromatic skeletons (ph) are bonded to each other through an alkylidene group or a methylene group having an aromatic hydrocarbon structure, moisture-resistance reliability and high flame retardancy in a halogen-free state are achieved by introducing a naphthylmethyl group or an anthrylmethyl group into an aromatic nucleus of the phenol resin.

The present invention relates to a heat-curable resin composition (hereinafter abbreviated as a "heat-curable resin composition (I)") including, as essential components, an epoxy resin (A) and a phenol resin (B), wherein the phenol resin (B) has a phenol resin structure having, as a basic skeleton, a structure in which a plurality of phenolic hydroxyl group-containing aromatic skeletons (ph) are bonded to each other through an alkylidene group or a methylene group having an aromatic hydrocarbon structure, and an aromatic nucleus of the phenol resin structure has a naphthylmethyl group or an anthrylmethyl group.

Further, the present invention relates to a semiconductor encapsulating material including, in addition to the epoxy resin (A) and the phenol resin (B) of the heat-curable resin composition (I), an inorganic filler at a ratio of 70% to 95% by mass in the composition.

Further, the present invention relates to a cured product produced by a curing reaction of the heat-curable resin composition (I).

Further, the present invention relates to an epoxy resin cured product produced by a curing reaction of the heat-curable resin composition (I).

Further, the present invention relates to a phenol resin having a phenol resin structure having, as a basic skeleton, a structure in which a plurality of phenolic hydroxyl group-containing aromatic skeletons (ph) are bonded to each other through an alkylidene group or a methylene group having an aromatic hydrocarbon structure, and aromatic nuclei in the phenol resin structure have naphthylmethyl groups or anthrylmethyl groups.

Further, the present invention relates to a heat-curable resin composition (hereinafter abbreviated as a "heat-curable resin composition (II)") including, as essential components, an epoxy resin (A') and a curing agent (B'), the epoxy resin (A') having an epoxy resin structure having, as a basic skeleton, a structure in which a plurality of glycidyloxy group-containing aromatic skeletons (ep) are bonded to each other through an alkylidene group or a methylene group having an aromatic hydrocarbon structure, and an aromatic nucleus in the epoxy resin structure has a naphthylmethyl group or an anthrylmethyl group.

Further, the present invention relates to a semiconductor encapsulating material including, in addition to the epoxy resin (A') and the curing agent (B') of the heat-curable resin composition (II), an inorganic filler at a ratio of 70% to 95% by mass in the composition.

Further, the present invention relates to a cured product produced by a curing reaction of the heat-curable resin composition (II).

Further, the present invention relates to an epoxy resin having an epoxy resin structure having, as a basic skeleton, a structure in which a plurality of glycidyloxy group-containing aromatic skeletons (ep) are bonded to each other through an alkylidene group or a methylene group having an aromatic hydrocarbon structure, and an aromatic nucleus in the epoxy resin structure has a naphthylmethyl group or an anthrylmethyl group.

### Advantageous Effects of Invention

According to the present invention, it is possible to provide a heat-curable resin composition having excellent fluidity and realizing moisture-resistance reliability suitable for recent electronic component-related materials and high flame retardancy in a halogen-free state for harmony with the environment, a cured product thereof, a semiconductor encapsulating material using the composition, and a phenol resin and epoxy resin which give these performances.

### Brief Description of Drawings

[Fig. 1] Fig. 1 is a GPC chart of phenol resin (A-1) produced in Example 1.
[Fig. 2] Fig. 2 is a ¹³C-NMR chart of phenol resin (A-1) produced in Example 1.
[Fig. 3] Fig. 3 is a MS spectrum of phenol resin (A-1) produced in Example 1.
[Fig. 4] Fig. 4 is a GPC chart of phenol resin (A-2) produced in Example 2.
[Fig. 5] Fig. 5 is a GPC chart of phenol resin (A-3) produced in Example 3.
[Fig. 6] Fig. 6 is a GPC chart of phenol resin (A-4) produced in Example 4.
[Fig. 7] Fig. 7 is a GPC chart of phenol resin (A-5) produced in Example 5.
[Fig. 8] Fig. 8 is a GPC chart of epoxy resin (E-1) produced in Example 6.
[Fig. 9] Fig. 9 is a ¹³C-NMR chart of epoxy resin (E-1) produced in Example 6.
[Fig. 10] Fig. 10 is a MS spectrum of epoxy resin (E-1) produced in Example 6.
[Fig. 11] Fig. 11 is a GPC chart of epoxy resin (E-2) produced in Example 7.
[Fig. 12] Fig. 12 is a GPC chart of epoxy resin (E-3) produced in Example 8.
[Fig. 13] Fig. 13 is a GPC chart of epoxy resin (E-4) produced in Example 9.
[Fig. 14] Fig. 14 is a GPC chart of epoxy resin (E-5) produced in Example 10.

### Description of Embodiments

The present invention is described in detail below.
A heat-curable resin composition (I) of the present invention is a heat-curable resin composition including, as essential components, an epoxy resin (A) and a phenol resin (B), the phenol resin (B) having a phenol resin structure having, as a basic skeleton, a structure in which a plurality of phenolic hydroxyl group-containing aromatic skeletons (ph) are bonded to each other through an alkylidene group or a methylene group having an aromatic hydrocarbon structure, and aromatic nuclei in the phenol resin structure have naphthylmethyl groups or anthrylmethyl groups.

That is, the phenol resin (B) has the phenol resin structure having, as the basic skeleton, the structure in which a plurality of phenolic hydroxyl group-containing aromatic skeletons (ph) are bonded to each other through an alkylidene group or a methylene group having an aromatic hydrocarbon structure, and an aromatic nucleus in the phenol resin structure has a naphthylmethyl group or an anthrylmethyl group. Therefore, aromaticity of the resin can be enhanced, and fluidity of the resin can be maintained. In addition, it is possible to improve affinity for an inorganic filler such as silica in application to a semiconductor encapsulating material, decrease the coefficient of thermal expansion of a cured product, and significantly improve moisture-resistance reliability and flame retardancy. In the present invention, the phenol resin (B) corresponds to a novel phenol resin of the present invention.

From the viewpoint of more improved balance between moisture-resistance reliability and flame retardancy, the content of the naphthylmethyl groups or anthrylmethyl groups in the aromatic nuclei of the phenol resin structure is preferably 10 to 200 in terms of ratio of total number of the naphthylmethyl groups or anthrylmethyl groups relative to a total number of 100 of the phenolic hydroxyl group-containing aromatic skeletons (ph). In particular, the content is preferably 15 to 120 from the viewpoint of the higher effect of improving curability, moldability, moisture-resistance reliability, and flame retardancy, more preferably in a range of 20 to 100 from the viewpoint of the excellent affinity for filler such as silica and excellent impregnation into a glass substrate, and the significant effect of the present invention, and particularly preferably in a range of 20 to 80.

On the other hand, Patent Literatures 2 and 3 describe that dichloromethyl naphthalene used as a condensing agent contains naphthylmethyl chloride as an impurity, and heat resistance is degraded unless the impurity content is 10% by mass or less. However, in the present invention, the naphthylmethyl group or anthrylmethyl group is positively introduced into the resin structure, and the ratio of the naphthylmethyl groups or anthrylmethyl groups present is 10 to 200 relative to the total number of 100 of the phenolic hydroxyl group-containing aromatic skeletons (ph), thereby causing no decrease in heat resistance and significantly improving moisture-resistance reliability represented by moisture resistance and solder resistance. Further, it is noteworthy that the heat-curable resin composition of the present invention has very low viscosity in spite of containing a condensed polycyclic skeleton with high bulkiness, thereby improving impregnation into an inorganic filler such as silica and a glass substrate and achieving good moisture-resistance reliability.

Here, the content of the naphthylmethyl groups or anthrylmethyl groups in the aromatic nuclei of the phenol resin structure, i.e., the total number of the naphthylmethyl groups or anthrylmethyl groups relative to the total number of 100 of the phenolic hydroxyl group-containing aromatic skeletons (ph), is equal to the total amount of a naphthylmethylating agent or anthrylmethylating agent (a2) based on the number of aromatic nuclei in a phenol resin raw material used for producing the phenol resin.

As described above, the phenol resin (B) in the heat-curable resin composition (I) contains, in its resin structure, a phenolic hydroxyl group-containing aromatic skeleton (the structural sites is abbreviated as a "phenolic hydroxyl group-containing aromatic skeleton (Ph1)" hereinafter) having a naphthylmethyl group or anthrylmethyl group in an aromatic nucleus, and a phenolic hydroxyl group-containing aromatic skeleton (the structural site is abbreviated as a "phenolic hydroxyl group-containing aromatic skeleton (Ph2)" hereinafter) not having a naphthylmethyl group or anthrylmethyl group in an aromatic nucleus. In the resin structure, these structural sites are linked to each other through an alkylidene group or aromatic hydrocarbon structure-containing methylene group (hereinafter referred to as the "methylene bridging group (X)").

Since the present invention has the above-described characteristic chemical structure, it is possible to enhance the aromatic content in the molecular structure and impart excellent heat resistance and flame retardancy to a cured product.

The phenolic hydroxyl group-containing aromatic skeleton (Ph1) can take various structures. Specifically, aromatic hydrocarbon groups represented by structural formulae Ph1-1 to Ph1-13 below, which are formed from phenol, naphthol, and a compound having an alkyl group as a substituent on the aromatic nucleus of phenol or naphthol, are preferred from the viewpoint of excellent heat resistance and moisture-resistance reliability.

Examples of the phenolic hydroxyl group-containing aromatic skeleton (Ph1) include those represented by structural formulae P1 to P13 below.

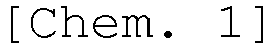

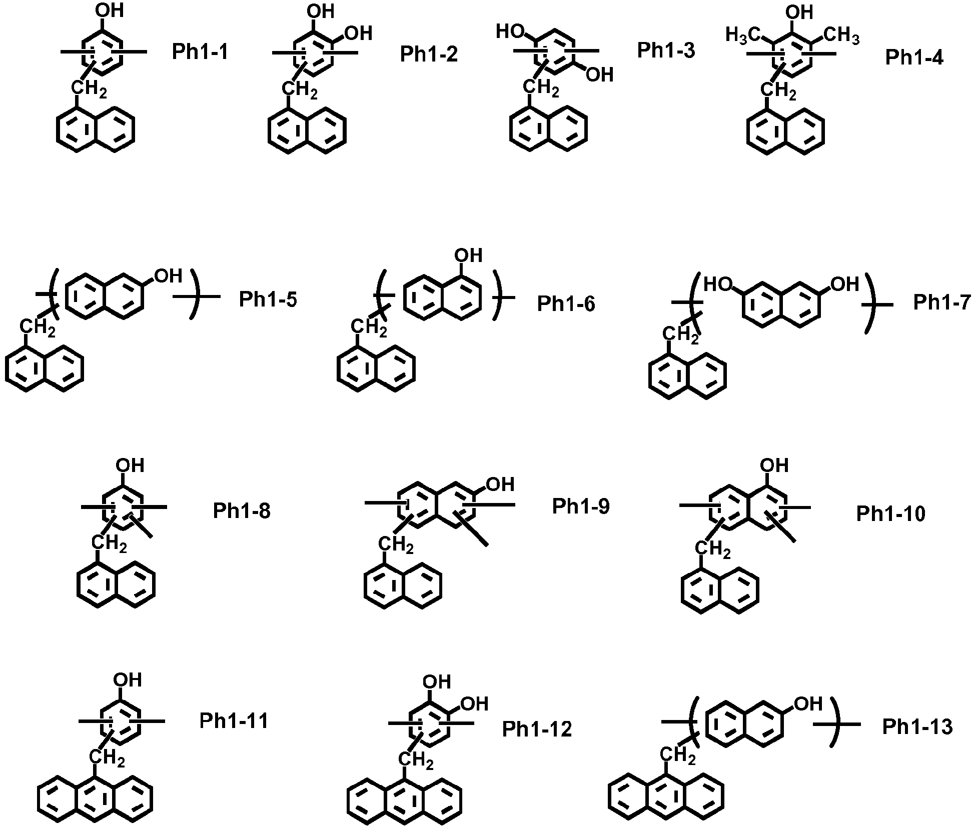

In these structures, when two or more bonds to other structural sites are positioned on a naphthalene skeleton, these bonds may be positioned on the same nucleus or different nuclei.

In the present invention, the structural formula Ph1-1 having a phenol skeleton is particularly preferred from the viewpoint of low viscosity and excellent curability, heat resistance, and moisture resistance and solder resistance. Also, a phenol skeleton having methyl groups as represented by the structural formula Ph1-4 is preferred from the viewpoint of the significant effect of improving heat resistance of moisture resistance and solder resistance. In addition, when the phenolic hydroxyl group-containing aromatic skeleton (Ph1) is positioned at a molecular end, skeletons represented by structural formulae Ph1-14 to Ph1-22 described below can be used.

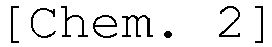

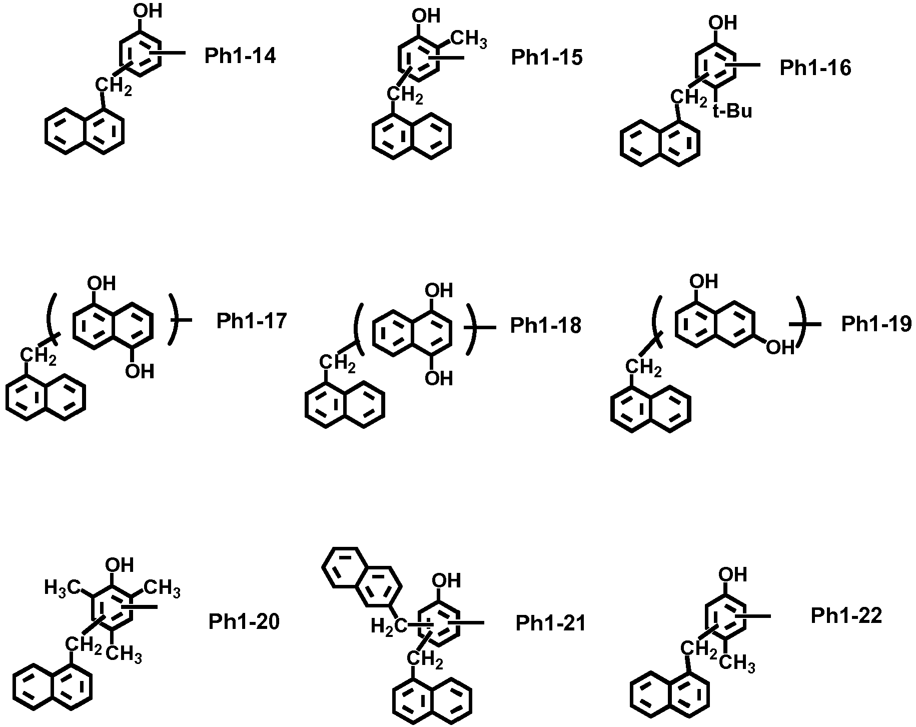

In these structures, when two or more bonds to other structural sites are positioned on a naphthalene skeleton, these bonds may be positioned on the same nucleus or different nuclei.
In the present invention, the structural formula Ph1-14 having a phenol skeleton is particularly preferred from the viewpoint of low viscosity and excellent curability, heat resistance, and moisture resistance and solder resistance. Also, a phenol skeleton having a methyl group as represented by the structural formulae Ph1-15, Ph1-20, or Ph1-22 is preferred from the viewpoint of the significant effect of improving heat resistance of moisture resistance and solder resistance.

On the other hand, as the phenolic hydroxyl group-containing aromatic skeleton (Ph2) not having the naphthylmethyl group or anthrylmethyl group in the aromatic nuclei, specifically, aromatic hydrocarbon groups represented by structural formulae Ph2-1 to Ph2-17 below, which are formed from phenol, naphthol, and a compound having an alkyl group as a substituent on the aromatic nucleus of phenol or naphthol, are preferred from the viewpoint of excellent heat resistance and moisture resistance and solder resistance.

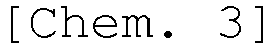

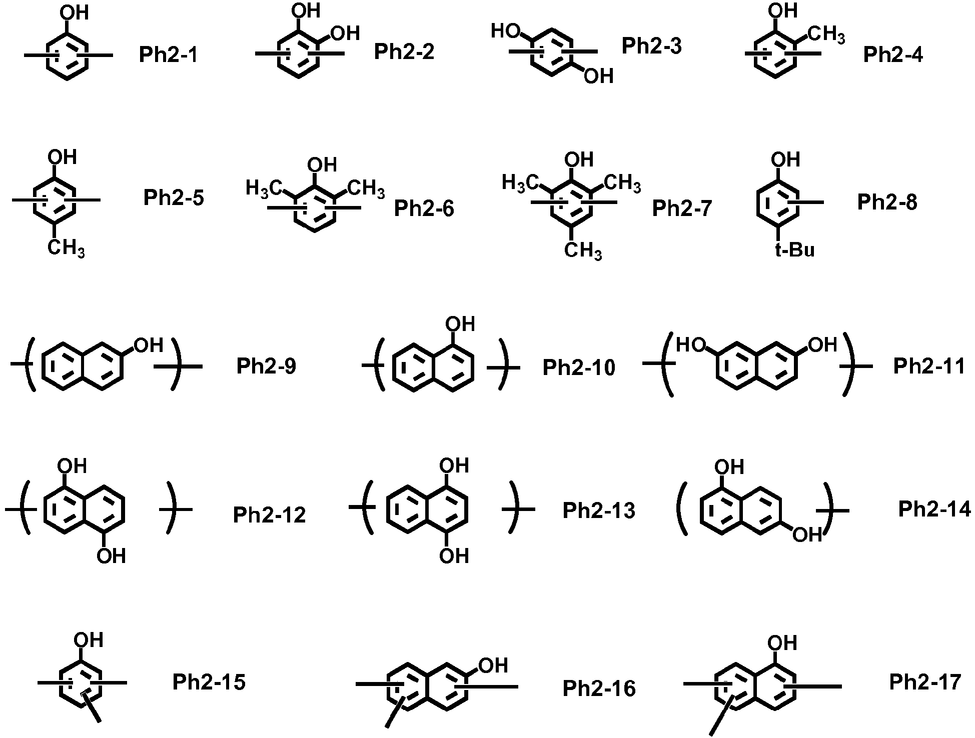

In these structures, when two or more bonds to other structural sites are positioned on a naphthalene skeleton, these bonds may be positioned on the same nucleus or different nuclei.

In the present invention, the structural formula Ph2-1 is particularly preferred from the viewpoint of excellent curability, and the structural formula Ph2-4 is preferred from the viewpoint of the moisture resistance and solder resistance.

In addition, when each of the structures is positioned at a molecular end, the structure is composed of a monovalent aromatic hydrocarbon group. In these structures, when two or more bonds to other structural sites are positioned on a naphthalene skeleton, these bonds may be positioned on the same nucleus or different nuclei.

Examples of the alkylidene group serving as the methylene bridging group (X) contained in the resin structure of the phenol resin (B) include a methylene group, an ethylidene group, a 1-propylidene group, a 2,2-propylidene group, a dimethylene group, a propane-1,1,3,3-tetrayl group, a n-butane-1,1,4,4-tetrayl group, a n-pentane-1,1,5,5-tetrayl group, and the like. Examples of the aromatic hydrocarbon structure-containing methylene group include groups represented by structural formulae X1 to X8 below.

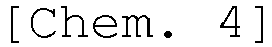

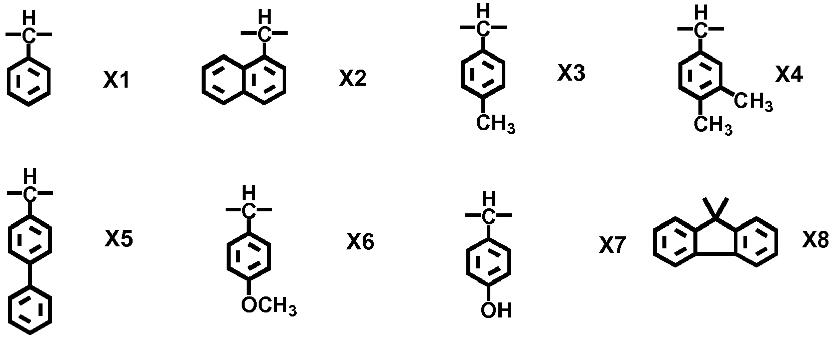

Among these, the methylene group and structures represented by the structural formulae X1, X2, and X5 are particularly preferred from the viewpoint of excellent flame retardancy of a cured product of the phenol resin (B).

The phenol resin (B) used in the present invention has the resin structure in which the phenolic hydroxyl group-containing aromatic skeleton (Ph1) and the phenolic hydroxyl group-containing aromatic skeleton (Ph2) are bonded to the phenolic hydroxyl group-containing aromatic skeleton (Ph1) or the phenolic hydroxyl group-containing aromatic skeleton (Ph2) through the methylene bridging group (X). This bonding can take any desired combination of bonding forms. The molecular structure of the phenol resin (B) composed of these structural sites includes a random copolymer or block copolymer having, as repeat units, structural sites represented by partial structural formulae B1 and B2 below

[Chem. 5]

-Ph1-X- B1

-Ph2-X- B2

wherein "Ph1" is the phenolic hydroxyl group-containing aromatic skeleton (Ph1), "Ph2" is the phenolic hydroxyl group-containing aromatic skeleton (Ph2), and "X" is the methylene bridging group (X), a polymer containing B1 present in a molecular chain of a polymer block having B2 as a repeat unit, a polymer having, as a branch point in a resin structure, a structural site represented by any one of structural formulae B3 to B8, or

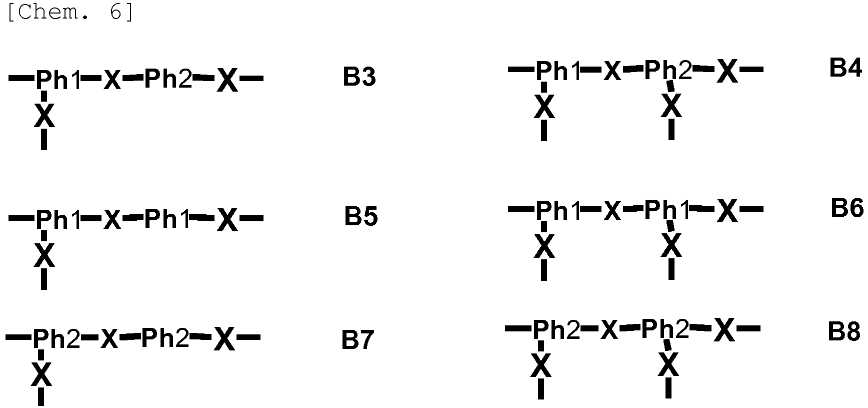

a polymer having a repeat unit represented by any one of B3 to B8 and a terminal structure represented by structural formula B9 or B10 below in its resin structure.

[Chem. 7]

-Ph1-X- B9

-Ph2-X- B10

Since the present invention has the above-described characteristic chemical structure, it is possible to enhance the aromatic content in the molecular structure and impart excellent heat resistance and flame retardancy to a cured product. In particular, the aromatic nucleus constituting the phenolic hydroxyl group-containing aromatic skeleton (Ph1) or the phenolic hydroxyl group-containing aromatic skeleton (Ph2) serving as the basic skeleton of the phenol resin (B) of the present invention is preferably composed of a phenyl group or an alkyl-substituted phenyl group because of the large effect of improving moisture resistance and solder resistance. The aromatic nucleus composed of a phenyl group or alkyl-substituted phenol group imparts toughness to a cured product and a condensed polycyclic skeleton disposed as a side chain exhibits low viscosity. Therefore, low thermal expansion and improved adhesion can be exhibited, thereby significantly improving moisture resistance and solder resistance and improving flame retardancy.

In addition, in the phenol resin (B), the naphthylmethyl group or the anthrylmethyl group present in the phenolic hydroxyl group-containing aromatic skeleton (Ph1) may have a multiple structure represented by the following structural formula (1) or (2):

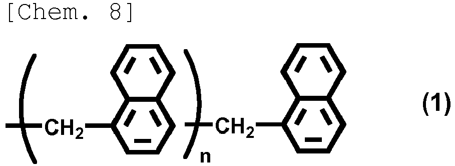

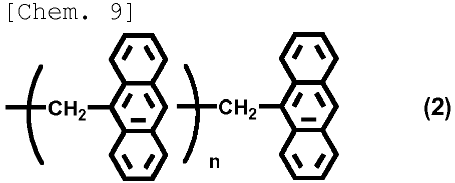

The structural formula (1) or (2) can take an average n value of 0 to 5, but in the present invention, a non-multiple structure, i.e., n = 0, is preferred from the viewpoint of the expression of excellent flame retardancy. In particular, the naphthylmethyl group is preferred in view of fluidity and flame retardancy.

Further, the phenol resin (B) of the present invention may contain an alkoxy group-containing aromatic hydrocarbon group bonded to an aromatic nucleus through the methylene bridging group (X). Examples of the alkoxy group-containing aromatic hydrocarbon group include group represented by the following structural formulae A1 to A13:

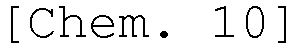

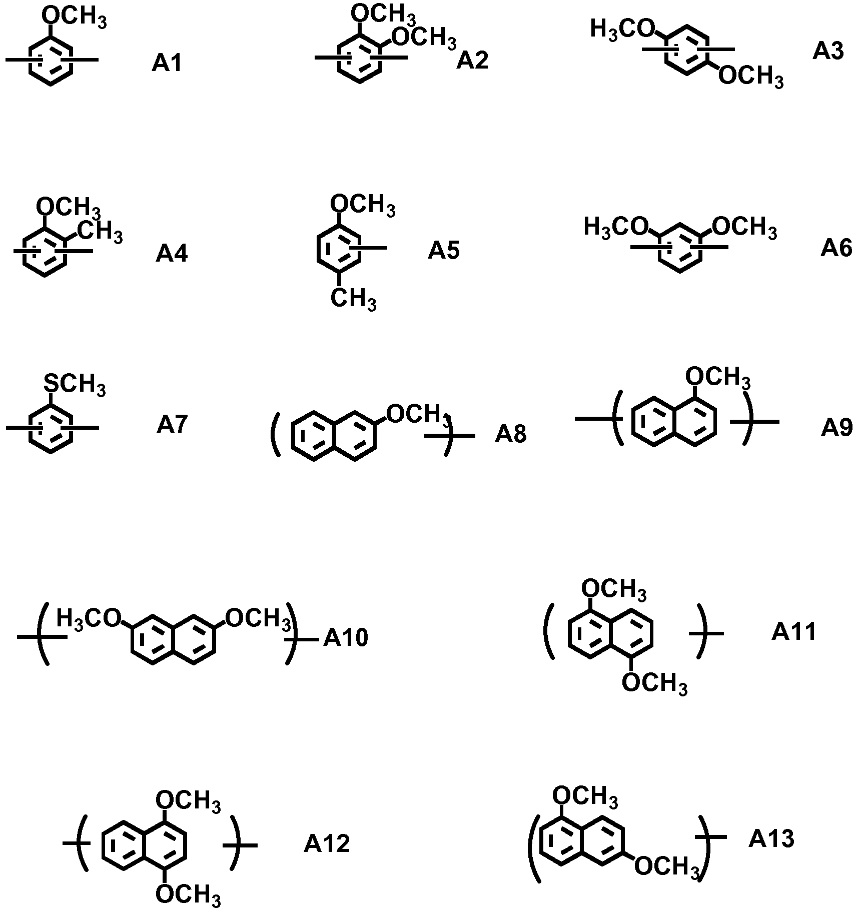

In the present invention, when the phenol resin (B) contains the alkoxy group-containing aromatic hydrocarbon group in its resin structure, the alkoxy group-containing aromatic hydrocarbon group having a structure represented by the structural formula A8 can exhibit excellent heat resistance and flame retardancy of an epoxy resin cured product and can significantly decrease the dielectric loss tangent.

In addition, in view of excellent fluidity during molding and excellent moisture resistance and solder resistance, the phenol resin (B) preferably has a melt viscosity at 150°C in a range of 0.1 to 50 dPa·s, particularly in a range of 0.1 to 20 dPa·s at 150°C, measured with an ICI viscometer. Further, in view of more improved heat resistance and flame retardancy of a cured product, the phenol resin (B) preferably has a hydroxyl equivalent in a range of 120 to 400 g/eq. In particular, with the hydroxyl equivalent in a range of 150 to 250 g/eq, heat resistance and flame retardancy of a cured product and balance with curability of the composition become excellent.

Further, in view of more improved flame retardancy and moisture resistance and solder resistance of a cured product, the ratio of total number of the phenolic hydroxyl group-containing aromatic hydrocarbon group (Ph1) present is preferably 10 to 200 relative to the total number of 100 of the phenolic hydroxyl group-containing aromatic hydrocarbon group (Ph1) having the naphthylmethyl group or anthrylmethyl group in the aromatic nucleus and the phenolic hydroxyl group-containing aromatic hydrocarbon group (Ph2) not having the naphthylmethyl group or anthrylmethyl group in the aromatic nucleus. In particular, the ratio is preferably 15 to 120 in view of the high effect of improving curability, moldability, moisture resistance and solder resistance, and flame retardancy, and is in a range of 20 to 100 because of the excellent impregnation into an inorganic filler such as silica in the prepared composition, the low coefficient of thermal expansion of a cured product, high adhesion, and significantly improved moisture resistance and solder resistance. In particular, with the ratio of 20 to 80, the moisture resistance and solder resistance is more improved.

The phenol resin (B) can be industrially produced by a production method described in detail below.

That is, the method for producing the phenol resin (B) is, for example, the method (method 1) of reacting a novolac resin with the naphthylmethylating agent or anthrylmethylating agent (a2), or the method (method 2) of reacting a phenol compound (Ph1') with a carbonyl compound (X') to produce a novolac phenol resin and then reacting the novolac phenol resin with the naphthylmethylating agent or anthrylmethylating agent (a2).

The novolac resin used in the method 1 has a resin structure in which the phenolic hydroxyl group-containing aromatic hydrocarbon group (Ph2) is bonded to the phenolic hydroxyl group-containing aromatic hydrocarbon group (Ph2) through the methylene bridging group (X), and which further contains the alkoxy group-containing aromatic hydrocarbon group through the methylene bridging group (X). In particular, a phenol novolac resin, a cresol novolac resin, and a naphthol novolac resin are preferred in view of high reactivity with the naphthylmethylating agent or anthrylmethylating agent (a2) and the excellent moisture-resistance reliability and flame retardancy of the resultant phenol resin.

Examples of the naphthylmethylating agent or anthrylmethylating agent (a2) used in the method 1 include 1-naphthylmethyl chloride, 2-naphthylmethyl chloride, (9-anthrylmethyl) chloride, 1-methoxymethylnaphthalene, 1-naphthylmethanol, 2-methoxymethylnaphthalene, 2-naphthylmethanol, 9-(methoxymethyl)anthracene, and 9-anthracenemethanol. Among these, 1-naphthylmethyl chloride, 2-naphthylmethyl chloride, and (9-anthrylmethyl) chloride are preferred in view of the point that the reaction can be performed without using a reaction catalyst, and the need for a purification step after the reaction is eliminated.

Examples of the phenol compound (Ph1') which can be used in the method 2 include unsubstituted phenol compounds such as phenol, resorcinol, hydroquinone, and the like; monosubstituted phenol compounds such as cresol, phenylphenol, ethylphenol, n-propylphenol, iso-propylphenol, tert-butylphenyl, and the like; disubstituted phenol compounds such as xylenol, methylpropylphenol, methylbutylphenol, methylhexylphenol, dipropylphenol, dibutylphenol, and the like; trisubstituted phenol compounds such as mesytol, 2,3,5-trimethylphenol, 2,3,6-trimethylphenol, and the like; and phenol compounds such as 1-naphthol, 2-naphthol, methylnaphthol, and the like.

Among these, 1-naphthol, 2-naphthol, cresol, and phenol are particularly preferred in view of the excellent flame retardancy and moisture resistance and solder resistance of a cured product and the excellent fluidity of the composition.

Examples of the carbonyl compound (X'), specifically a carbonyl group-containing compound (a3), include aliphatic aldehydes such as formaldehyde, acetaldehyde, propionaldehyde, and the like; dialdehydes such as qlyoxal and the like; aromatic aldehydes such as benzaldehyde, 4-methylbenzaldehyde, 3,4-dimethylbenzaldehyde, 4-biphenylaldehyde, naphthylaldehyde, and the like; and ketone compounds such as benzophenone, fluorenone, indanone, and the like.

Among these, formaldehyde, benzaldehyde, 4-biphenylaldehyde, and naphthylaldehyde are preferred in view of the excellent flame retardancy of a cured product.

The reaction of the phenol compound (Ph1') with the carbonyl compound (X') can be performed by heating 0.01 to 0.9 moles of the carbonyl compound (X') per mole of the phenol compound (Ph1') in the presence of a catalyst. The polymerization catalyst used is not particularly limited, but is preferably an acid catalyst, for example, an inorganic acid such as hydrochloric acid, sulfuric acid, phosphoric acid, or the like, an organic acid such as methanesulfonic acid, p-toluenesulfonic acid, oxalic acid, or the like, or a Lewis acid such as boron trifluoride, anhydrous aluminum chloride, zinc chloride, or the like. The amount of use thereof is preferably in a range of 0.1% to 5% by mass relative to the total mass of the raw materials charged.

If required, an organic solvent can be used during the reaction. Examples of the organic solvent which can be used include, but are not limited to, methyl cellosolve, ethyl cellosolve, toluene, xylene, methyl isobutyl ketone, and the like. The amount of the organic solvent used is generally 10 to 500% by mass and preferably 30 to 250% by mass relative to the total mass of the raw materials charged. In addition, the reaction temperature is generally 40°C to 250°C and preferably in a range of 100°C to 200°C, and the reaction time is generally 1 to 20 hours.

When the resultant polyhydric hydroxyl compound has large coloring, an antioxidant or a reducing agent may be added to the compound in order to suppress the coloring. Examples of the antioxidant include, but are not particularly limited to, hindered phenol compounds such as 2,6-dialkylphenol derivatives, and the like; divalent sulfur-based compounds; and phosphite compounds containing trivalent phosphorus atom. Examples of the reducing agent include, but are not particularly limited to, hypophosphorous acid, phosphorous acid, thiosulfuric acid, sulfurous acid, hydrosulfite, and salts thereof, zinc, and the like.

After the reaction, neutralization or water washing is performed until the pH value of the reaction mixture becomes 3 to 7, preferably 4 to 7. The neutralization or water washing may be performed according to a usual method. For example, when an acid catalyst is used, a basic material such as sodium hydroxide, potassium hydroxide, sodium carbonate, ammonia, triethylenetetramine, aniline, or the like can be used as a neutralizing agent. In the neutralization, a buffer such as phosphoric acid or the like may be previously added, or the pH value may be adjusted to 3 to 7 with oxalic acid or the like after being brought into the basic side. After the neutralization or water washing, the product can be concentrated by distilling off the unreacted raw materials mainly containing the phenol compound (Ph1'), the organic solvent, and byproducts by heating under reduced pressure, thereby producing the target polyhydric hydroxyl compound. The unreacted raw materials recovered can be reused. In addition, a microfiltration step is more preferably introduced into the treatment operation after the completion of reaction because inorganic salts and foreign matters can be removed by purification.

Like in the method 1, examples of the naphthylmethylating agent or anthrylmethylating agent (a2) used in the method 2 include 1-naphthylmethyl chloride, 2-naphthylmethyl chloride, (9-anthrylmethyl) chloride, 1-methoxymethyl naphthalene, 1-naphthylmethanol, 2-methoxymethyl naphthalene, 2-naphthylmethanol, 9-(methoxymethyl) anthracene, and 9-anthracene methanol. Among these, 1-naphthylmethyl chloride, 2-naphthylmethyl chloride, and (9-anthrylmethyl) chloride are preferred in view of the point that the reaction can be performed without using a reaction catalyst, and the need for a purification step after the reaction is eliminated.

The reaction of the novolac resin with the naphthylmethylating agent or anthrylmethylating agent (a2) in the method 1 or the reaction of the novolac resin with the naphthylmethylating agent or anthrylmethylating agent (a2) in the method 2 can be performed at a temperature condition of 50°C to 200°C, preferably under the reaction condition of 70°C to 180°C. The reaction catalyst is preferably an acid catalyst, for example, an inorganic acid such as hydrochloric acid, sulfuric acid, phosphoric acid, or the like, an organic acid such as methanesulfonic acid, p-toluenesulfonic acid, oxalic acid, or the like, or a Lewis acid such as boron trifluoride, anhydrous aluminum chloride, zinc chloride, or the like. The amount of use thereof is preferably in a range of 0.1 to 5% by mass relative to the total mass of the raw materials charged.

When 1-naphthylmethyl chloride, 2-naphthylmethyl chloride, or (9-anthrylmethyl) chloride is used as the naphthylmethylating agent or anthrylmethylating agent (a2), the reaction can be effected using self-generated hydrogen halide without the need to use the reaction catalyst. When hydrogen halide is not generated in the early stage of reaction, about 0.1% to 5% by mass of water or hydrochloric acid can be added to promote the self generation of hydrogen halide. In this case, the hydrogen chloride gas generated is preferably rapidly discharged to the outside of the reaction system, followed by neutralization and ditoxification with alkali water or the like.

The reaction time is generally about 1 to 50 hours so that the naphthylmethylating agent or anthrylmethylating agent (a2) used as a raw material is lost. When 1-naphthylmethyl chloride, 2-naphthylmethyl chloride, or (9-anthrylmethyl) chloride is used, the reaction time is the time required until hydrogen chloride gas is substantially not generated, the chloride compound as a raw material is lost, and a chlorine content resulting from the raw material (a2) is not detected. In the actual reaction, the reaction temperature can be preferably controlled so that hydrogen chloride gas is rapidly generated and can be stably discharged to the outside of the system. Depending on the reaction temperature, the reaction time at such a reaction temperature is about 1 hour to 25 hours.

In addition, the end of the reaction is preferably determined by confirming the disappearance of xylyrene dichloride used as a raw material in high-performance liquid chromatography or gas chromatography and confirming no change in molecular weight distribution in gel permeation chromatography (GPC), and no change in refractive index.

Further, the end of reaction is preferably determined by confirming the conditions until the melt viscosity of the final resultant resin no longer changes.
The melt viscosity may be measured by a method using an ICI cone-plate viscometer, a B-type viscometer, or an E-type viscometer.
Since the reaction product produced as described above contains a large amount of unreacted phenol compound remaining, the unreacted phenol can be removed by a desired method such as distillation, water washing, or the like to produce the phenol resin (B) of the present invention.

If required, an organic solvent can be used during the reaction. Examples of the organic solvent which can be used include, but are not limited to, methyl cellosolve, ethyl cellosolve, toluene, xylene, methyl isobutyl ketone, and the like. However, when 1-naphthylmethyl chloride, 2-naphthylmethyl chloride, or (9-anthrylmethyl) chloride is used, it is preferred not to use an alcohol organic solvent because of the occurrence of side reaction. The amount of the organic solvent used is generally 10 to 500% by mass and preferably 30 to 250% by mass relative to the total mass of the raw materials charged.

When the resultant polyhydric hydroxyl compound has large coloring, an antioxidant or a reducing agent may be added to the compound in order to suppress the coloring. Examples of the antioxidant include, but are not particularly limited to, hindered phenol compounds such as 2,6-dialkylphenol derivatives, and the like; divalent sulfur-based compounds; and phosphite compounds containing trivalent phosphorus atom. Examples of the reducing agent include, but are not particularly limited to, hypophosphorous acid, phosphorous acid, thiosulfuric acid, sulfurous acid, hydrosulfite, and salts thereof, zinc, and the like.

After the reaction, neutralization or water washing is performed until the pH value of the reaction mixture becomes 3 to 7, preferably 4 to 7. The neutralization or water washing may be performed according to a usual method. For example, when an acid catalyst is used, a basic material such as sodium hydroxide, potassium hydroxide, sodium carbonate, ammonia, triethylenetetramine, aniline, or the like can be used as a neutralizing agent. In the neutralization, a buffer such as phosphoric acid or the like may be previously added, or the pH value may be adjusted to 3 to 7 with oxalic acid or the like after being brought into the basic side.

In the heat-curable resin composition (I) of the present invention, the phenol resin (B) may be used alone but may be combined with another curing agent (b) for an epoxy resin within a range where the effect of the present invention is not impaired. Specifically, the curing agent (b) for an epoxy resin can be used in a range where the amount of the phenol resin (B) is 30% by mass or more and preferably 40% by mass or more relative to the total mass of the curing agent.

Examples of the other curing agent (b) for an epoxy resin which can be combined with the phenol resin (B) of the present invention include amine compounds, amide compounds, acid anhydride compounds, phenol compounds other than the phenol resin (B), and aminotriazine-modified phenol resins (polyhydric phenol compounds each containing phenol nuclei connected to each other with melamine or benzoquanamine).

Examples of the phenol compounds other than the phenol resin (B) include novolac resins such as phenol novolac resins, cresol novolac resins, phenol novolac resins, cresol novolac resins, naphthol novolac resins, naphthol-phenol co-condensed novolac resins, naphthol-cresol co-condensed novolac resins, and the like; methoxy aromatic structure-containing phenol resins such as phenol resins having a resin structure in which a methoxynaphthalene skeleton is bonded to an aromatic nucleus of any one of these novolac resins through a methylene group, phenol resins having a resin structure in which a methoxyphenyl skeleton is bonded to an aromatic nucleus of any one of these novolac resins through a methylene group, and the like; aralkyl-type phenol resins, such as

phenol aralkyl resins represented by the following structural formula:

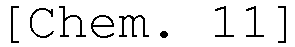

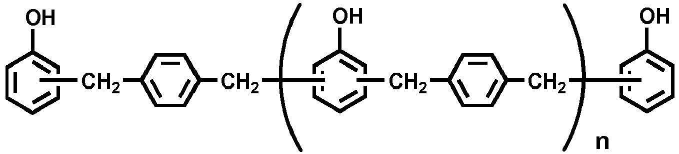

(wherein n is a repeat unit and is an integer of 0 or more), naphthol aralkyl resins represented by the following structural formula:

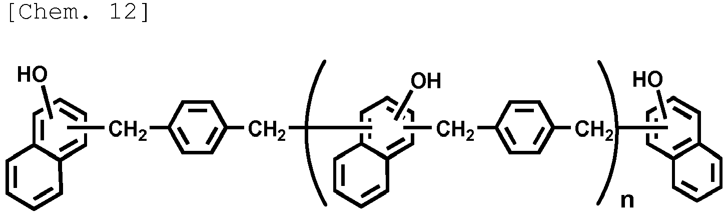

(wherein n is a repeat unit and is an integer of 0 or more), biphenyl-modified phenol resins represented by the following structural formula:

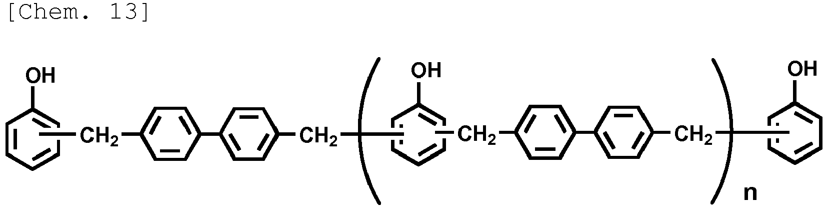

(wherein n is a repeat unit and is an integer of 0 or more), biphenyl-modified naphthol resins represented by the following structural formula:

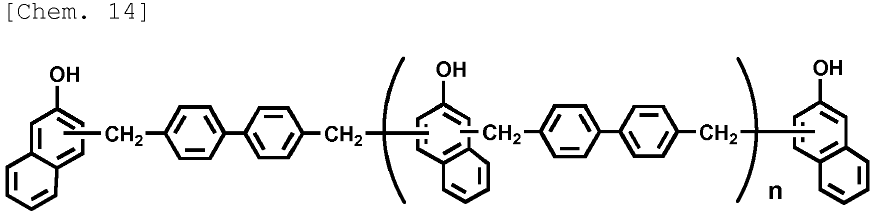

(wherein n is a repeat unit and is an integer of 0 or more), and the like; phenol resins having a resin structure in which a methoxynaphthalene skeleton is bonded to an aromatic nucleus of any one of these aralkyl-type resins through a methylene group, and phenol resins having a resin structure in which a methoxyphenyl skeleton is bonded to an aromatic nucleus of any one of these aralkyl-type phenol resins through a methylene group; novolac resins each containing aromatic methylene as a bridging group and represented by the following structural formula:

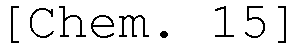

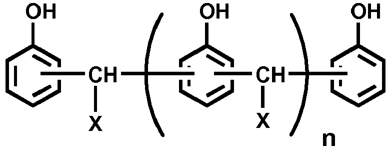

(wherein X represents a phenyl group or a biphenyl group, and n is a repeat unit and is an integer of 0 or more); trimethylolmethane resins; tetraphenylolethane resins; and dicyclopentadiene phenol addition-type phenol resins.

Among these, a resin containing many aromatic skeletons in its molecular structure is preferred from the viewpoint of the flame retardant effect. Examples thereof which are preferred in view of excellent flame retardancy include phenol novolac resins, cresol novolac resins, novolac resins having aromatic methylene as a bridging group, phenol aralkyl resins, naphthol aralkyl resins, naphthol novolac resins, naphthol-phenol co-condensed novolac resins, naphthol-cresol co-condensed novolac resins, biphenyl-modified phenol resins, biphenyl-modified naphthol resins, methoxy aromatic structure-containing phenol resins, aminotriazine-modified phenol resins.

Next, examples of the epoxy resin (A) used in the heat-curable resin composition (I) of the present invention include naphthalene-type epoxy resins such as diglycidyloxy naphthalene, 1,1-bis(2,7-diglycidyloxynaphthyl)methane, 1-(2,7-diglycidyloxynaphthyl)-1-(2'-glycidyloxynaphthyl)methane, and the like; bisphenol epoxy resins such as bisphenol A epoxy resins, bisphenol F epoxy resins, and the like; novolac epoxy resins such as phenol novolac epoxy resins, cresol novolac epoxy resins, bisphenol A novolac epoxy resins, naphthol novolac epoxy resins, biphenyl novolac epoxy resins, naphthol-phenyl co-condensed novolac epoxy resins, naphthol-cresol co-condensed novolac epoxy resins, and the like; epoxy resins having a resin structure in which a methoxynaphthalene skeleton is bonded to an aromatic nucleus of any one of these novolac epoxy resins through a methylene group and epoxy resins having a resin structure in which a methoxyphenyl skeleton is bonded to an aromatic nucleus of any one of these novolac epoxy resins through a methylene group; phenol aralkyl epoxy resins represented by the following structural formula B1:

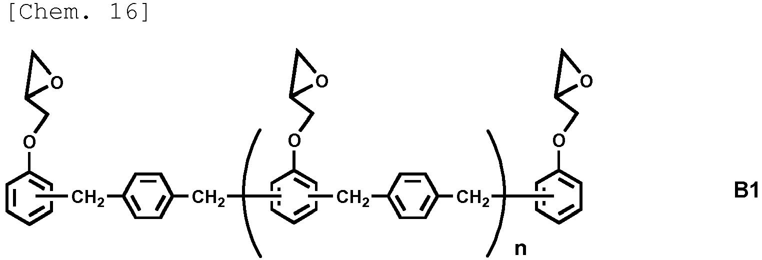

(wherein n is a repeat unit and is an integer of 0 or more), naphthol aralkyl epoxy resins represented by the following structural formula B2:

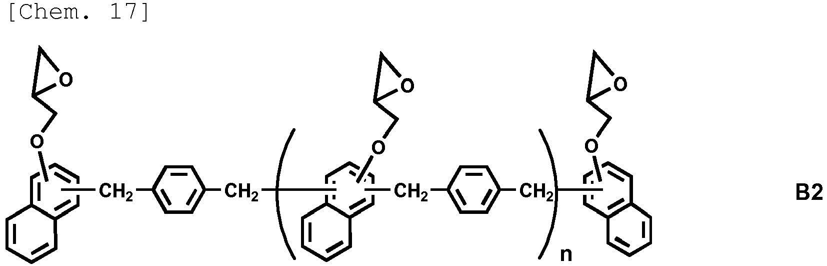

(wherein n is a repeat unit and is an integer of 0 or more), biphenyl epoxy resins represented by the following structural formula B3:

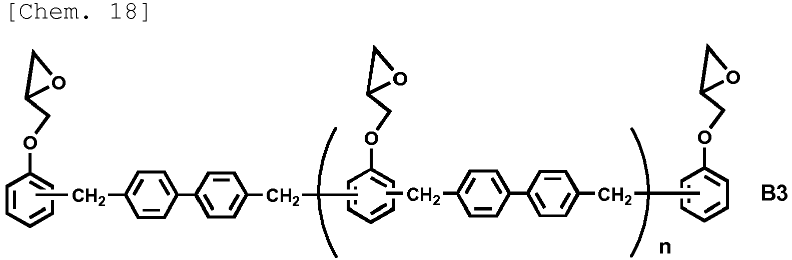

(wherein n is a repeat unit and is an integer of 0 or more), novolac epoxy resins each having aromatic methylene as a bridging group and represented by the following structural formula B4:

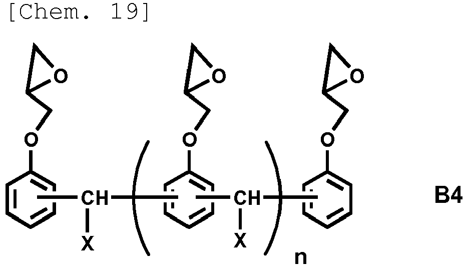

(wherein X represents a phenyl group or a biphenyl group, and n is a repeat unit and is an integer of 0 or more); epoxy resins having a resin structure in which a methoxynaphthalene skeleton is bonded to an aromatic nucleus of any one of these the aralkyl-type phenol resins through a methylene group, and epoxy resins having a resin structure in which a methoxyphenyl skeleton is bonded to an aromatic nucleus of any one of these aralkyl-type phenol resins through a methylene group; tetramethylbiphenyl epoxy resins; triphenylmethane epoxy resins; tetraphenylethane epoxy resins; and dicyclopentadiene phenol addition reaction-type epoxy resins. These epoxy resins may be used alone or as a mixture of two or more. Among these, naphthalene-type epoxy resins, naphthol novolac epoxy resins, phenol aralkyl epoxy resins, biphenyl epoxy resins, alkoxy group-containing novolac epoxy resins, and alkoxy group-containing aralkyl epoxy resins are preferred in view of excellent flame retardancy and dielectric characteristics.

The mixing amounts of the epoxy resin (A) and the phenol resin (B) in the heat-curable resin composition (I) of the present invention are preferably such that the amount of active group in the curing agent containing the phenol resin (B) is 0.7 to 1.5 equivalents relative to a total of 1 equivalent of epoxy groups in the epoxy resin (A) from the viewpoint of good physical properties of the resultant cured product.

If required, the heat-curable resin composition (I) of the present invention may be properly combined with a curing accelerator. As the curing accelerator, various compounds can be used, and for example, a phosphorus-base compound, a tertiary amine, imidazole, an organic acid metal salt, a Lewis acid, an amine complex salt, and the like ca be used. In particular, in application to a semiconductor encapsulating material, from the viewpoint of excellent curability, heat resistance, electric characteristics, moisture-resistance reliability, etc, triphenylphosphine is preferred as the phosphorus-based compound, and 1,8-diazabicyclo-[5.4.0]-undecene (DBU) is preferred as the tertiary amine.

Another heat-curable resin composition (II) of the present invention include, as essential components, an epoxy resin (A') and a curing agent (B'), the epoxy resin (A') having an epoxy resin structure having, as a basic skeleton, a structure in which a plurality of glycidyloxy group-containing aromatic skeletons (ep) are bonded to each other through an alkylidene group or a methylene group having an aromatic hydrocarbon structure, and an aromatic nucleus of the epoxy resin structure has a naphthylmethyl group or an anthrylmethyl group.

That is, the epoxy resin (A') in the heat-curable resin composition (II) is produced by epoxidation through reaction of the phenol resin (B) constituting the heat-curable resin composition (I) with epichlorohydrin, and thus has the basic skeleton common to the phenol resin (B). Therefore, aromaticity of the resin can be enhanced, and fluidity of the resin can be maintained. In addition, it is possible to improve affinity for an inorganic filler such as silica in application to a semiconductor encapsulating material, decrease the coefficient of thermal expansion of a cured product, and significantly improve moisture-resistance reliability and flame retardancy. In the present invention, the epoxy resin (A') corresponds to a novel epoxy resin of the present invention.

From the viewpoint of more improved balance between moisture-resistance reliability and flame retardancy, the ratio of total number of the naphthylmethyl groups or anthrylmethyl groups present is preferably 10 to 200 relative to the total number of 100 of the glycidyl group-containing aromatic skeletons (ep). In particular, the ratio is preferably 15 to 120 from the viewpoint of the higher effect of improving curability, moldability, moisture-resistance reliability, and flame retardancy. Further, the ratio is preferably in a range of 20 to 100 from the viewpoint of the excellent affinity for filler such as silica, excellent impregnation into a glass substrate, and the significant effect of the present invention, and particularly preferably in a range of 20 to 80.

Here, the total number of the naphthylmethyl groups or anthrylmethyl groups relative to the total number of 100 of the glycidyloxy group-containing aromatic skeletons (ep) is equal to the total amount of a naphthylmethylating agent or anthrylmethylating agent (a2) relative to the number of aromatic nuclei in a phenol resin raw material used for producing the phenol resin serving as a precursor of the epoxy resin.

As described above, the epoxy resin (A') in the heat-curable resin composition (II) contains, in its resin structure, a glycidyloxy group-containing aromatic skeleton (the structural site is abbreviated as a "glycidyloxy group-containing aromatic skeleton (Ep1)" hereinafter) having a naphthylmethyl group or anthrylmethyl group in an aromatic nucleus, and a glycidyloxy group-containing aromatic skeleton (the structural site is abbreviated as a "glycidyloxy group-containing aromatic skeleton (Ep2)" hereinafter) not having a naphthylmethyl group or anthrylmethyl group in an aromatic nucleus. In the resin structure, these structural sites are linked to each other through the methylene bridging group (X).

Examples of the glycidyloxy group-containing aromatic skeleton (Ep1) include those represented by structural formulae Ep1-1 to Ep1-13 below.

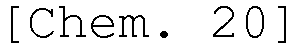

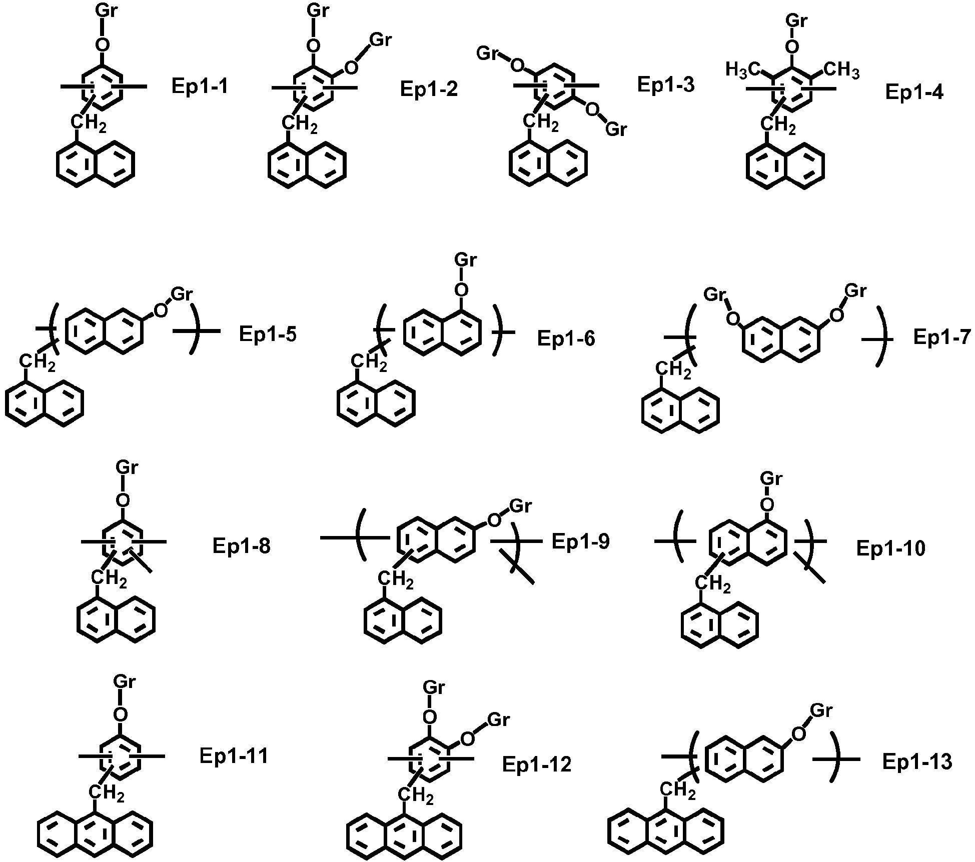

In these formulae, "Gr" represents a glycidyloxy group, and when two or more bonds to other structural sites are positioned on a naphthalene skeleton, these bonds may be positioned on the same nucleus or different nuclei.

In the present invention, the structural formula Ep1-1 is particularly preferred from the viewpoint of low viscosity and excellent curability, heat resistance, and moisture resistance and solder resistance. Also, a skeleton having methyl groups as represented by the structural formula Ep1-4 is preferred from the viewpoint of the significant effect of improving heat resistance and moisture resistance and solder resistance.

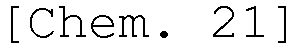

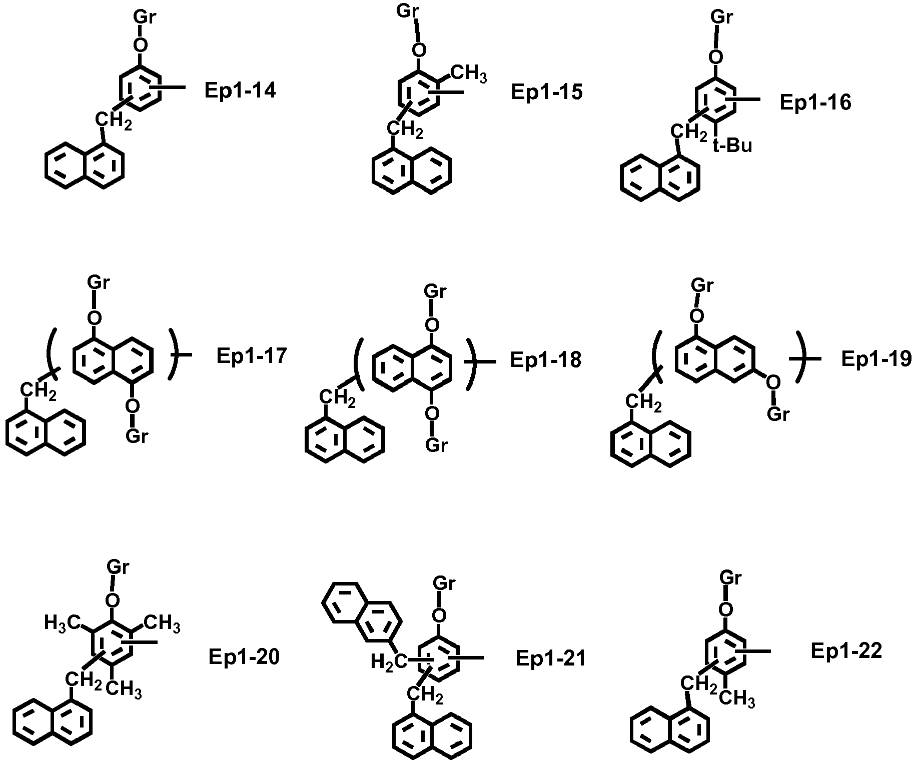

In these formulae, "Gr" represents a glycidyloxy group, and when two or more bonds to other structural sites are positioned on a naphthalene skeleton, these bonds may be positioned on the same nucleus or different nuclei.

In the present invention, the structural formula Ep1-14 is particularly preferred from the viewpoint of low viscosity and excellent curability, heat resistance, and moisture resistance and solder resistance. Also, a phenol skeleton having methyl groups as represented by the structural formulae Ep1-15, Ep1-20, or Ep1-22 is preferred from the viewpoint of the significant effect of improving heat resistance and moisture resistance and solder resistance.

On the other hand, as the glycidyloxy group-containing aromatic skeleton (Ep2) not having the naphthylmethyl group or anthrylmethyl group in the aromatic nucleus, specifically, aromatic hydrocarbon groups represented by structural formulae Ep2-1 to Ep2-17 below, which are formed from phenol, naphthol, and a compounds having an alkyl group as a substituent on the aromatic nucleus of phenol or naphthol, are preferred from the viewpoint of excellent heat resistance and moisture resistance and solder resistance.

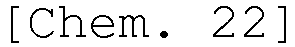

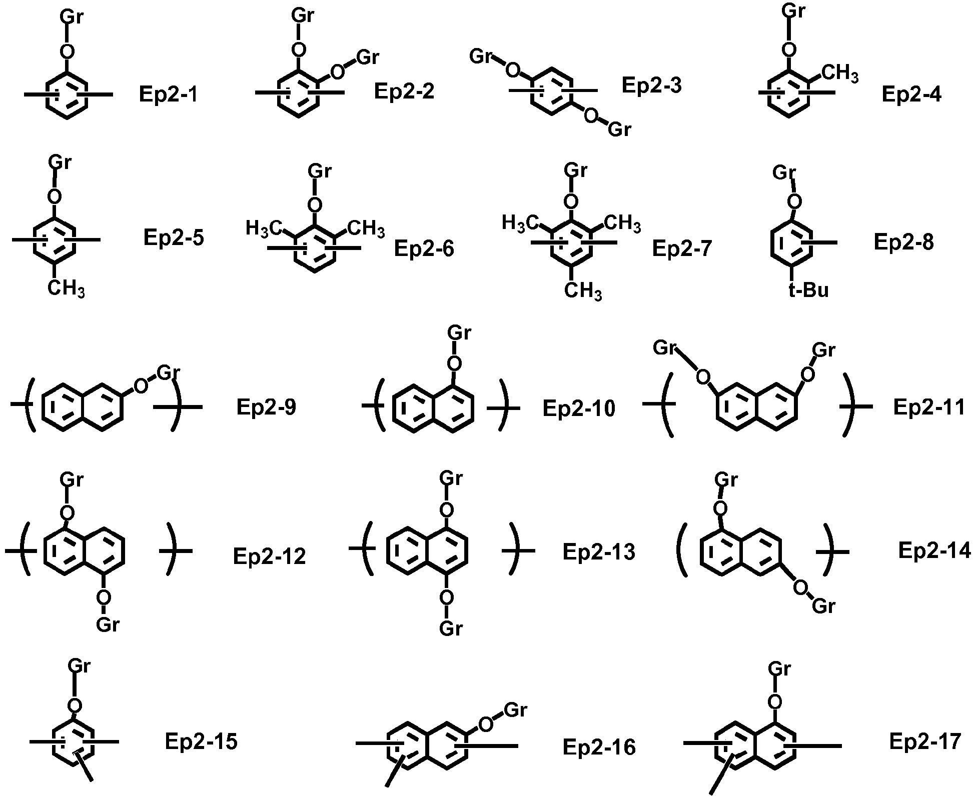

In these formulae, "Gr" represents a glycidyloxy group, and when two or more bonds to other structural sites are positioned on a naphthalene skeleton, these bonds may be positioned on the same nucleus or different nuclei.

In the present invention, the structural formula Ep2-1 is particularly preferred from the viewpoint of excellent curability, and the structural formula Ep2-4 is preferred from the viewpoint of the moisture resistance and solder resistance.

Like for the phenol resin in the heat-curable resin composition (I), examples of the methylene bridging group (X) contained in the resin structure of the epoxy resin (A') include structures represented by the above-described structural formulae X1 to X5.

The epoxy resin (A') used in the present invention has the resin structure in which the glycidyloxy group-containing aromatic skeleton (Ep1) and the glycidyloxy group-containing aromatic skeleton (Ep2) are bonded to the glycidyloxy group-containing aromatic skeleton (Ep1) or the glycidyloxy group-containing aromatic skeleton (Ep2) through the methylene bridging group (X). This bonding can take any desired combination of bonding forms. The molecular structure of the epoxy resin composed of these structural sites includes a random copolymer or block copolymer having, as repeat units, structural sites represented by partial structural formulae E1 and E2 below

[Chem. 23]

-Ep1-X- E1

-Ep2-X- E2

wherein "Ep1" is the glycidyloxy group-containing aromatic skeleton (Ep1), "Ep2" is the glycidyloxy group-containing aromatic skeleton (Ep2), and "X" is the methylene bridging group (X), a polymer containing E1 present in a molecular chain of a polymer block having E2 as a repeat unit, a polymer having, as a branch point in a resin structure, a structural site represented by any one of structural formulae E3 to E8, or

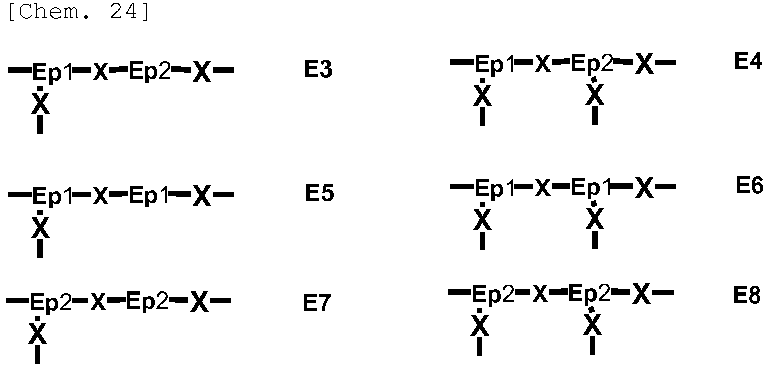

a polymer having a repeat unit represented by any one of E3 to E8 and a terminal structure represented by structural formula E9 or E10 below in the resin structure.

[Chem. 25]

-Ep1-X- E9

-Ep2-X- E10

Since the present invention has the above-described characteristic chemical structure, it is possible to enhance the aromatic content in the molecular structure and impart excellent heat resistance and flame retardancy to a cured product. In particular, the aromatic nucleus constituting the glycidyloxy group-containing aromatic skeleton (Ep1) or the glycidyloxy group-containing aromatic skeleton (Ep2) serving as the basic skeleton of the epoxy resin (A') of the present invention is preferably composed of a phenyl group or an alkyl-substituted phenyl group because of the large effect of improving moisture resistance and solder resistance. The aromatic nucleus composed of a phenyl group or alkyl-substituted phenyl group imparts toughness to a cured product and a condensed polycyclic skeleton disposed as a side chain exhibits low viscosity. Therefore, low thermal expansion and improved adhesion can be exhibited, thereby significantly improving moisture resistance and solder resistance and improving flame retardancy.

In addition, in the epoxy resin, the naphthylmethyl group or the anthrylmethyl group present in the glycidyloxy group-containing aromatic skeleton (Ep1) may have a multiple structure represented by the following structural formula (1) or (2):

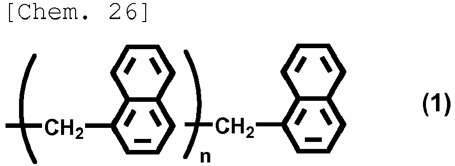

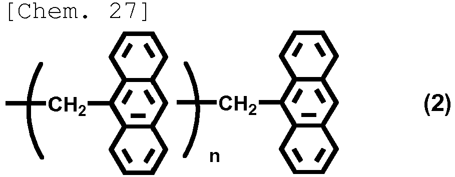

The structural formula (1) or (2) can take an average n value of 0 to 5, but in the present invention, a non-multiple structure, i.e., n = 0, is preferred from the viewpoint of the expression of excellent flame retardancy.

Further, the epoxy resin (A') of the present invention may contain, as a structural site, an alkoxy group-containing aromatic hydrocarbon group bonded through the methylene bridging group (X). Examples of the alkoxy group-containing aromatic hydrocarbon group include groups represented by the following structural formulae A1 to A13:

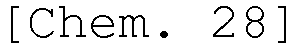

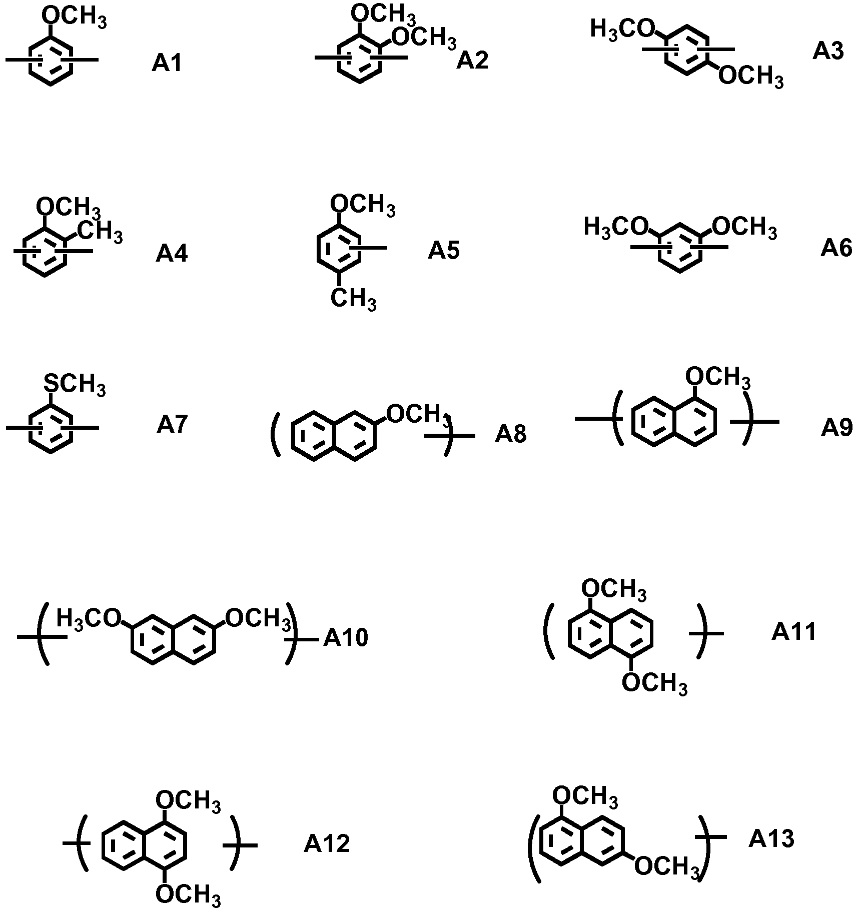

In the present invention, when the epoxy resin (A') contains the alkoxy group-containing aromatic hydrocarbon group in its resin structure, the alkoxy group-containing aromatic hydrocarbon group having a structure represented by the structural formula A8 can exhibit excellent heat resistance and flame retardancy of an epoxy resin cured product and can significantly decrease the dielectric loss tangent.

In addition, in view of more improved heat resistance and flame retardancy of a cured product, the epoxy resin (A') preferably has an epoxy equivalent in a range of 180 to 500 g/eq. Further, in view of excellent fluidity during molding and excellent moisture resistance and solder resistance of a cured product, the epoxy resin (A') preferably has a melt viscosity at 150°C in a range of 0.1 to 50 dPa·s, particularly in a range of 0.1 to 10 dPa·s, measured with an ICI viscometer. In particular, the epoxy equivalent is preferably in a range of 200 to 400 g/eq because of excellent moisture resistance and solder resistance and flame retardancy of a cured product and excellent balance with curability of the composition.

Further, in view of more improved flame retardancy and moisture resistance and solder resistance of a cured product, the ratio of total number of the glycidyloxy group-containing aromatic hydrocarbon group (Ep1) present is preferably in a range of 10 to 200 relative to the total number of 100 of the glycidyloxy group-containing aromatic hydrocarbon group (Ep1) having the naphthylmethyl group or anthrylmethyl group and the glycidyloxy group-containing aromatic hydrocarbon group (Ep2). In particular, the ratio is preferably 15 to 120 in view of the high effect of improving curability, moldability, moisture-resistance reliability, and flame retardancy, and is in a range of 20 to 100 because of the excellent impregnation into a glass substrate and an inorganic filler such as silica in the composition, the lower coefficient of thermal expansion of a cured produce, higher adhesion, and significantly improved moisture resistance and solder resistance. In particular, with the ratio in a range of 20 to 80, the moisture resistance and solder resistance is more improved.

The epoxy resin (A') can be produced by a production method described in detail below. That is, the method for producing the epoxy resin (A') is, for example, the method of producing the phenol resin in the heat-curable resin composition (I) according to the above-described method and then reacting the phenol resin with epichlorohydrin. Specifically, the method includes adding 2 to 10 moles of epichlorohydrin per mole of phenolic hydroxyl group in the phenol resin and then performing reaction for 0.5 to 10 hours at a temperature of 20°C to 120°C while collectively or gradually adding 0.9 to 2.0 moles of a basic catalyst per mole of phenolic hydroxyl group. The basic catalyst may be used as either a solid or an aqueous solution. When the aqueous solution is used, the method may be one in which the aqueous solution is continuously added, and water and epichlorohydrin are continuously distilled off from the reaction mixture under reduced pressure or normal pressure and further fractionated so that water is removed, and epichlorohydrin is continuously returned to the reaction mixture.

In the case of industrial production, new epichlorohydrin to be charged is used in a first batch for production of the epoxy resin, but in subsequent batches, the epichlorohydrin recovered from the crude reaction product is preferably combined with new epichlorohydrin corresponding to a consumption loss by the reaction. In this case, the epichlorohydrin contains impurities derived from the reaction, such as glycidol, epichlorohydrin and water, an organic solvent, etc. The epichlorohydrin used is not particularly limited but, for example, epichlorohydrin, epibromohydrin, β-methylepichlorohydrin, or the like can be used. In particular, epichlorohydrin is preferred because of easily industrial availability.

Examples of the basic catalyst include alkaline-earth metal hydroxides, alkali metal carbonates, alkali metal hydroxides, and the like. In particular, in view of excellent catalytic activity for epoxy resin synthesis reaction, alkali metal hydroxides, for example, sodium hydroxide, potassium hydroxide, and the like, are preferred. When the basic catalyst is used, it may be used in the form of a 10 to 55 mass% aqueous solution or a solid form. In addition, combination with an organic solvent can increase the reaction rate of synthesis of the epoxy resin. Examples of the organic solvent include, but are not particularly limited to, ketones such as acetone, methyl ethyl ketone, and the like; alcohols such as methanol, ethanol, 1-propyl alcohol, isopropyl alcohol, 1-butanol, secondary butanol, tertiary butanol, and the like; cellosolves such as methyl cellosolve, ethyl cellosolve, and the like; ethers such as tetrahydrofuran, 1,4-dioxane, 1,3-dioxane, diethoxyethane, and the like; and aprotic polar solvents such as acetonitrile, dimethylsulfoxide, dimethylformamide, and the like. These organic solvents may be used alone or in combination of two or more in order to adjust polarity.

The product of the epoxidation reaction is washed with water and then unreacted epichlorohydrin and the solvent used are distilled off by distillation under heating and reduced pressure. Further, in order to produce the epoxy resin containing little hydrolyzable halogen, the resultant epoxy resin can be again dissolved in an organic solvent such as toluene, methyl isobutyl ketone, methyl ethyl ketone, or the like, and an aqueous solution of an alkali metal hydroxide such as sodium hydroxide, potassium hydroxide, or the like can be added to effect further reaction. In this case, a phase transfer catalyst, such as a quaternary ammonium salt, a crown ether, or the like, may be present for improving the reaction rate. When the phase transfer catalyst is used, the amount of use thereof is preferably in a range of 0.1 to 3.0% by mass relative to the epoxy resin used. After the completion of reaction, the produced salt can be removed by filtration and water-washing, and a solvent such as toluene or methyl isobutyl ketone can be distilled off by heating under reduced pressure to produce the epoxy resin with high purity.

In the heat-curable resin composition (II) of the present invention, the epoxy resin (A') produced by the production method of the present invention may be used alone, but may be combined with another epoxy resin (a') in a range where the effect of the present invention is not impaired. When the other epoxy resin (a') is combined, the ratio of the epoxy resin (A) of the present invention in the whole of the epoxy resin components is preferably 30% by mass or more, particularly 40% by mass or more.

Examples of the other epoxy resin (a') which can be combined with the epoxy resin (A') of the present invention include various epoxy resins, for example, naphthalene-type epoxy resins such as diglycidyloxy naphthalene, 1,1-bis(2,7-diglycidyloxynaphthyl)methane, 1-(2,7-diglycidyloxynaphthyl)-1-(2'-glycidyloxynaphthyl)methane, and the like; bisphenol epoxy resins such as bisphenol A epoxy resins, bisphenol F epoxy resins, and the like; novolac epoxy resins such as phenol novolac epoxy resins, cresol novolac epoxy resins, bisphenol A novolac epoxy resins, naphthol novolac epoxy resins, biphenyl novolac epoxy resins, naphthol-phenyl co-condensed novolac epoxy resins, naphthol-cresol co-condensed novolac epoxy resins, and the like; epoxy resins having a resin structure in which a methoxynaphthalene skeleton is bonded to an aromatic nucleus of any one of these novolac epoxy resins through a methylene group and epoxy resins having a resin structure in which a methoxyphenyl skeleton is bonded to an aromatic nucleus of any one of these novolac epoxy resins through a methylene group; phenol aralkyl-type epoxy resins represented by the following structural formula B1:

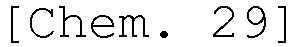

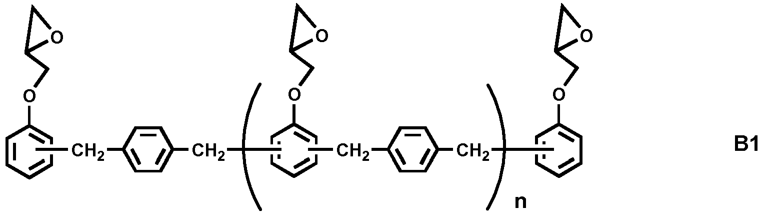

(wherein n is a repeat unit and is an integer of 0 or more), naphthol aralkyl epoxy resins represented by the following structural formula B2:

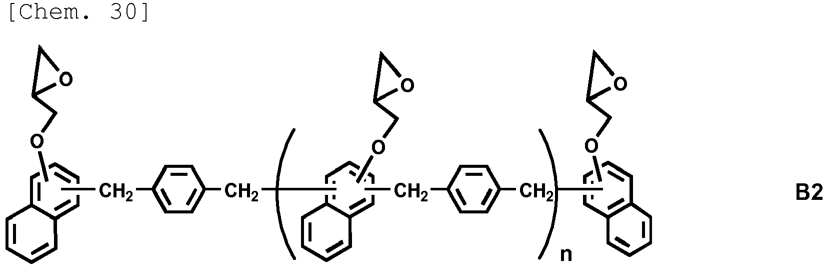

(wherein n is a repeat unit and is an integer of 0 or more), biphenyl epoxy resins represented by the following structural formula B3:

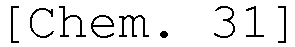

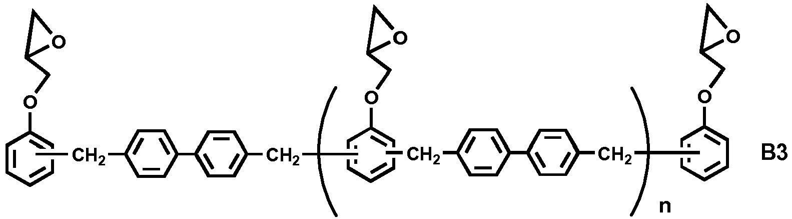

(wherein n is a repeat unit and is an integer of 0 or more), and novolac epoxy resins each having aromatic methylene as a bridging group and represented by the following structural formula B4:

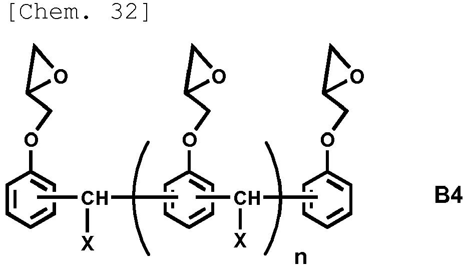

(wherein X represents a phenyl group or a biphenyl group, and n is a repeat unit and is an integer of 0 or more); epoxy resins having a resin structure in which a methoxynaphthalene skeleton is bonded to an aromatic nucleus of any one of these aralkyl-type epoxy resins through a methylene group, and epoxy resins having a resin structure in which a methoxyphenyl skeleton is bonded to an aromatic nucleus of any one of these aralkyl-type epoxy resins through a methylene group; and other epoxy resins such as tetramethylbiphenyl epoxy resins, triphenylmethane epoxy resins, tetraphenylethane epoxy resins, and dicyclopentadiene phenol addition reaction-type epoxy resins. These epoxy resins may be used alone or as a mixture or two or more.

Among these, naphthalene-based epoxy resins, naphthol novolac epoxy resins, phenol aralkyl epoxy resins, biphenyl epoxy resins, alkoxy group-containing novolac epoxy resins, and alkoxy group-containing aralkyl epoxy resins are preferred in view of excellent flame retardancy and dielectric characteristics.

As the curing agent (B') used in the heat-curable resin composition (II) of the present invention, various known curing agents for epoxy resins, for example, an amine compound, an amide compound, an acid anhydride compound, a phenol compound, and the like, can be used. Examples of the amine compound diaminodiphenylmethane, diethylene triamine, triethylene tetramine, diaminodiphenylsulfone, isophorone diamine, imidazole, BF₃-amine complex, guanidine derivatives, and the like. Examples of the amide compound include dicyandiamide, polyamide resins synthesized from linolenic acid dimer and ethylenediamine, and the like. Examples of the acid anhydride compound include phthalic anhydride, trimellitic anhydride, pyromellitic anhydride, maleic anhydride, tetrahydrophthalic anhydride, methyltetrahydrophthalic anhydride, methylnadic anhydride, hexahydrophthalic anhydride, methylhexahydrophthalic anhydride, and the like. Examples of the phenol compound include novolac resins such as phenol novolac resins, cresol novolac resins, naphthol novolac resins, naphthol-phenol co-condensed novolac resins, naphthol-cresol co-condensed novolac resins, and the like; methoxy aromatic structure-containing phenol resins such as phenol resins having a resin structure in which a methoxynaphthalene skeleton is bonded to an aromatic nucleus of any one of these novolac resins through a methylene group, phenol resins having a resin structure in which a methoxyphenyl skeleton is bonded to an aromatic nucleus of any one of these novolac resins through a methylene group, and the like; aralkyl-type phenol resins such as phenol aralkyl resins represented by the following structural formula:

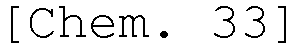

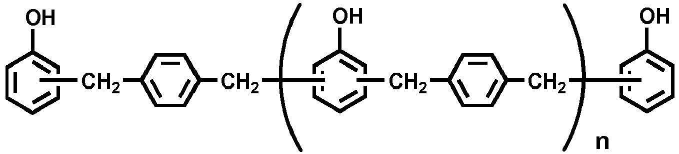

(wherein n is a repeat unit and is an integer of 0 or more), naphthol aralkyl resins represented by the following structural formula:

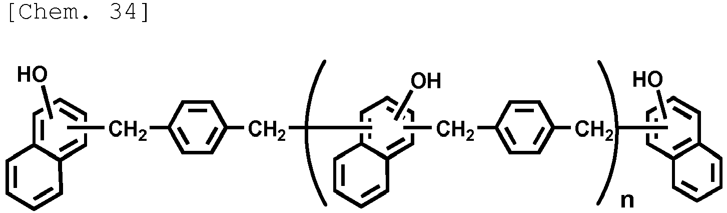

(wherein n is a repeat unit and is an integer of 0 or more), biphenyl-modified phenol resins represented by the following structural formula:

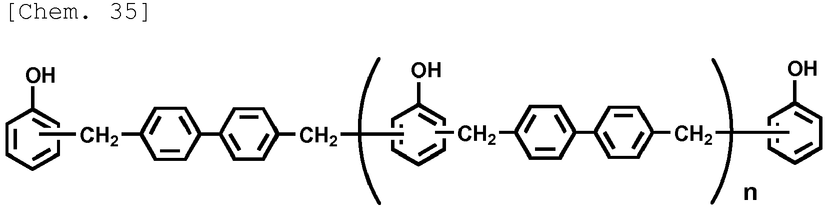

(wherein n is a repeat unit and is an integer of 0 or more), biphenyl-modified naphthol resins represented by the following structural formula:

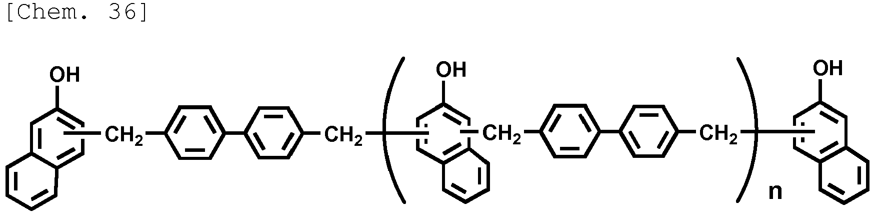

(wherein n is a repeat unit and is an integer of 0 or more), and the like; phenol resins having a resin structure in which a methoxynaphthalene skeleton is bonded to an aromatic nucleus of any one of these aralkyl-type phenol resins through a methylene group, and phenol resins having a resin structure in which a methoxyphenyl skeleton is bonded to an aromatic nucleus of any one of these aralkyl-type phenol resins through a methylene group; novolac resins each containing aromatic methylene as a bridging group and represented by the following structural formula:

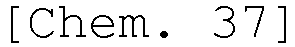

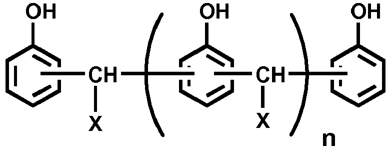

(wherein X represents a phenyl group or a biphenyl group, and n is a repeat unit and is an integer of 0 or more); and polyhydric phenol compounds such as trimethylolmethane resins, tetraphenylolethane resins, dicyclopentadiene phenol addition-type phenol resins, aminotriazine-modified phenol resins (polyhydric phenol compounds each containing phenol nuclei connected to each other with melamine or benzoquanamine), and the like.

Among these, a resin containing many aromatic skeletons in its molecular structure is preferred from the viewpoint of the flame retardant effect. Examples thereof which are preferred in view of excellent flame retardancy include phenol novolac resins, cresol novolac resins, novolac resins having aromatic methylene as a bridging group, phenol aralkyl resins, naphthol aralkyl resins, naphthol novolac resins, naphthol-phenol co-condensed novolac resins, naphthol-cresol co-condensed novolac resins, biphenyl-modified phenol resins, biphenyl-modified naphthol resins, methoxy aromatic structure-containing phenol resins, and aminotriazine-modified phenol resins. In addition, in order to improve fluidity, it is preferred to use the resin together with dihydroxyphenol such as resorcin, catechol, hydroquinone, or the like, bisphenol such as bisphenol F, bisphenol A, or the like, or dihydroxynaphthalene such as 2,7-dihydroxynaphthalene, 1,6-dihydroxynaphthalene, or the like.

However, in the present invention, the phenol resin (B) used in the heat-curable resin composition (I) is particularly preferred from the viewpoint of the significant effect of improving heat resistance and moisture resistance and solder resistance. Further, from the viewpoint of excellent moisture resistance and solder resistance and flame retardancy, the phenol resin preferably has a structure in which the phenolic hydroxyl group-containing aromatic skeleton (Ph1) having the naphthylmethyl group or anthrylmethyl group in the aromatic nucleus is represented by the formula Ph1-14, Ph1-15, Ph1-20, or Ph1-22, the phenolic hydroxyl group-containing aromatic skeleton (Ph2) not having the naphthylmethyl group or anthrylmethyl group in the aromatic nucleus is represented by the formula Ph2-1 or Ph2-4, and the methylene bridging group (X) is represented by the structural formula X1, X2, or X5.

The amounts of the epoxy resin (A') and the curing agent (B') mixed in the heat-curable resin composition (II) of the present invention are not particularly limited, but are preferably such that the amount of active group in the curing agent (B') is 0.7 to 1.5 equivalents relative to a total of 1 equivalent of epoxy groups in the epoxy resin including the epoxy resin (A') from the viewpoint of good physical properties of the resultant cured product.

If required, the heat-curable resin composition (II) of the present invention may be properly further combined with a curing accelerator. As the curing accelerator, various compounds can be used and, for example, a phosphorus-base compound, a tertiary amine, imidazole, an organic acid metal salt, a Lewis acid, an amine complex salt, and the like ca be used. In particular, in application to a semiconductor encapsulating material, from the viewpoint of excellent curability, heat resistance, electric characteristics, moisture-resistance reliability, etc, triphenylphosphine is preferred as the phosphorus-base compound, and 1,8-diazabicyclo-[5.4.0]-undecene (DBU) is preferred as the tertiary amine.

In the heat-curable resin compositions (I) and (II) detailed above, the phenol resin (B) in the heat-curable resin composition (I) and the epoxy resin (A') in the heat-curable resin composition (II) have the excellent effect of imparting flame retardancy, and thus a cure product has good flame retardancy even if not mixed with a flame retardant in common use. However, in order to exhibit higher flame retardancy, for example, in the field of semiconductor encapsulating materials, a non-halogen flame retardant (C) containing substantially no halogen atom may be mixed within a range where moldability in an encapsulation step and reliability of a semiconductor device are not degraded.

Although the heat-curable resin composition containing the non-halogen flame retardant (C) contains substantially no halogen atom, the resin composition may contain halogen atoms due to trace amounts of impurities at about 5000 ppm or less which are derived from, for example, epichlorohydrin contained in the epoxy resin.

Examples of the non-halogen flame retardant (C) include a phosphorus-based flame retardant, a nitrogen-based flame retardant, a silicone-based flame retardant, an inorganic flame retardant, an organic metal salt-based flame retardant, and the like. Use of these flame retardants is not particularly limited, and they may be used alone or in combination of a plurality of flame retardants of the same type or different types.

As the phosphorus-based flame retardant, either an inorganic type or an organic type can be used. Examples of an inorganic compound include red phosphorus; ammonium phosphates such as monoammonium phosphate, diammonium phosphate, triammonium phosphate, ammonium polyphosphate, and the like; and inorganic nitrogen-containing phosphorus compounds such as phosphoric amide, and the like.

The red phosphorus is preferably surface-treated for preventing hydrolysis or the like. Examples of a surface treatment method include (i) a method of coating with an inorganic compound such as magnesium hydroxide, aluminum hydroxide, zinc hydroxide, titanium hydroxide, bismuth oxide, bismuth hydroxide, bismuth nitrate, or a mixture thereof, (ii) a method of coating with a mixture of an inorganic compound, such as magnesium hydroxide, aluminum hydroxide, zinc hydroxide, or titanium hydroxide, and a thermosetting resin, such as a phenol resin, (iii) a doubly coating method of coating with a film of an inorganic compound such as magnesium hydroxide, aluminum hydroxide, zinc hydroxide, or titanium hydroxide, and coating the film with a thermosetting resin such as a phenol resin, and the like.

Examples of the organic phosphorus compound include general-purpose organic phosphorus compounds such as phosphate compounds, phosphonic acid compounds, phosphinic acid compounds, phosphine oxide compounds, phospholan compounds, organic nitrogen-containing phosphorus compounds, and the like; cyclic organic phosphorus compounds such as 9,10-dihydro-9-oxa-10-phosphaphenanthrene=10-oxide, 10-(2,5-dihydroxyphenyl)-10H-9-oxa-10-phosphaphenanthrene=10-oxide, 10-(2,7-dihydroxynaphthyl)-10H-9-oxa-10-phosphaphenanthrene=10-oxide, and the like; and derivatives produced by reaction of the phosphorus compounds with a compound such as an epoxy resin, a phenol resin, or the like.

The mixing amount is appropriately selected according to the type of the phosphorus-based flame retardant, the other components of the heat-curable resin composition, and the desired degree of flame retardancy. For example, when red phosphorus is used as the non-halogen flame retardant, the flame retardant is preferably mixed in a rage of 0.1 to 2.0 parts by mass in 100 parts by mass of the heat-curable resin composition containing all of the epoxy resin, the curing agent, the non-halogen flame retardant, filler, and the other additives. Similarly, when the organic phosphorus compound is used, it is preferably mixed in a range of 0.1 to 10.0 parts by mass, particularly preferably in a range of 0.5 to 6.0 parts by mass.

When the phosphorus-based flame retardant is used, the phosphorus-based flame retardant may be combined with hydrotalcite, magnesium hydroxide, a boron compound, zirconium oxide, a black dye, calcium carbonate, zeolite, zinc molybdate, activated carbon, or the like.

Examples of the nitrogen-based flame retardant include triazine compounds, cyanuric acid compounds, isocyanuric acid compounds, phenothiazine, and the like, and the triazine compounds, the cyanuric acid compounds, and the isocyanuric acid compounds are preferred.

Examples of the triazine compounds include melamine, acetoguanamine, benzoguanamine, melon, melam, succinoguanamine, ethylenedimelamine, melamine polyphosphate, triguanamine, and other compounds such as (i) aminotriazine sulfate compounds such as guanylmelamine sulfate, melem sulfate, melam sulfate, and the like; (ii) co-condensates of phenols, such as phenol, cresol, xylenol, butylphenol, and nonylphenol, with melamines, such as melamine, benzoguanamine, acetoguanamine, and formguanamine, and formaldehyde; (iii) mixtures of the co-condensates (ii) and phenol resins such as phenol-formaldehyde condensates; and (iv) the co-condensates (ii) and the mixtures (iii) further modified with tung oil, isomerized linseed oil, or the like.

Examples of the cyanuric acid compounds include cyanuric acid, melamine cyanurate, and the like.

The amount of the nitrogen-based flame retardant mixed is appropriately selected according to the type of the nitrogen-based flame retardant, the other components of the heat-curable resin composition, and the desired degree of flame retardancy. For example, the nitrogen-based flame retardant is preferably mixed in a range of 0.05 to 10 parts by mass, particularly preferably in a range of 0.1 to 5 parts by mass, in 100 parts by mass of the heat-curable resin composition containing all of the epoxy resin, the curing agent, the non-halogen flame retardant, filler, and the other additives.

In addition, the nitrogen-based flame retardant may be used in combination with a metal hydroxide, a molybdenum compound, or the like.

The silicone-based flame retardant is not particularly limited and can be used as long as it is an organic compound containing a silicon atom. Examples thereof include silicone oil, silicone rubber, silicone resins, and the like.

The amount of the silicone-based flame retardant mixed is appropriately selected according to the type of the silicone-based flame retardant, the other components of the heat-curable resin composition, and the desired degree of flame retardancy. For example, the silicone-based flame retardant is preferably mixed in a range of 0.05 to 20 parts by mass in 100 parts by mass of the heat-curable resin composition containing all of the epoxy resin, the curing agent, the non-halogen flame retardant, filler, and the other additives. In addition, the silicone-based flame retardant may be used in combination with a molybdenum compound, alumina, or the like.

Examples of the inorganic flame retardant include metal hydroxides, metal oxides, metal carbonate compounds, metal powders, boron compounds, low-melting-point glass, and the like.

Examples of the metal hydroxides include aluminum hydroxide, magnesium hydroxide, dolomite, hydrotalcite, calcium hydroxide, barium hydroxide, zirconium hydroxide, and the like.

Examples of the metal oxides include zinc molybdate, molybdenum trioxide, zinc stannate, tin oxide, aluminum oxide, iron oxide, titanium oxide, manganese oxide, zirconium oxide, zinc oxide, molybdenum oxide, cobalt oxide, bismuth oxide, chromium oxide, nickel oxide, copper oxide, tungsten oxide, and the like.

Examples of the metal carbonate compounds include zinc carbonate, magnesium carbonate, calcium carbonate, barium carbonate, basic magnesium carbonate, aluminum carbonate, iron carbonate, cobalt carbonate, titanium carbonate, and the like.

Examples of the metal powders include powders of aluminum, iron, titanium, manganese, zinc, molybdenum, cobalt, bismuth, chromium, nickel, copper, tungsten, tin, and the like.

Examples of the boron compounds include zinc borate, zinc metaborate, barium metaborate, boric acid, borax, and the like.

Examples of the low-melting-point glass include Seaplea (Bokusui Brown Co., Ltd.), hydrated glass SiO₂-MgO-H₂O, and PbO-B₂O₃-based, ZnO-P₂O₅-MgO-based, P₂O₅-B₂O₃-PbO-MgO-based, P-Sn-O-F-based, PbO-V₂O₅-TeO₂-based, Al₂O₃-H₂O-based, and lead borosilicate-based glass compounds.

The amount of the inorganic flame retardant mixed is appropriately selected according to the type of the inorganic flame retardant, the other components of the heat-curable resin composition, and the desired degree of flame retardancy. For example, the inorganic flame retardant is preferably mixed in a range of 0.05 to 20 parts by mass, particularly preferably in a range of 0.5 to 15 parts by mass, in 100 parts by mass of the heat-curable resin composition containing all of the epoxy resin, the curing agent, the non-halogen flame retardant, filler, and the other additives.

Examples of the organic metal salt-based flame retardant include ferrocene, acetylacetonate metal complexes, organic metal carbonyl compounds, organic cobalt salt compounds, organic sulfonic acid metal salts, compounds each having an ionic bond or coordinate bond between a metal atom and an aromatic compound or heterocyclic compound, and the like.

The amount of the organic metal salt-based flame retardant mixed is appropriately selected according to the type of the organic metal salt-based flame retardant, the other components of the heat-curable resin composition, and the desired degree of flame retardancy. For example, the organic metal salt-based flame retardant is preferably mixed in the range of 0.005 to 10 parts by mass in 100 parts by mass of the heat-curable resin composition containing all of the epoxy resin, the curing agent, the non-halogen flame retardant, filler, and the other additives.

If required, an inorganic filler can be mixed in the heat-curable resin composition of the present invention. Examples of the inorganic filler include fused silica, crystalline silica, alumina, silicon nitride, aluminum hydroxide, and the like. When the amount of the inorganic filler mixed is particularly increased, the fused silica is preferably used. Although either crushed or spherical fused silica can be used, the spherical fused silica is preferably mainly used for increasing the amount of the fused silica mixed and suppressing an increase in melt viscosity of a molding material. In order to further increase the amount of the spherical silica mixed, the grain size distribution of the spherical silica is preferably properly adjusted. The filling rate is preferably as high as possible in view of flame retardancy, and particularly preferably 65% by mass or more of the whole amount of the heat-curable resin composition. In the use for an application such as a conductive paste, conductive filler such as a silver powder, a copper powder, or the like can be used.

If required, various compounding agents such as a silane coupling agent, a mold release agent, a pigment, an emulsifier, etc. can be added to the heat-curable resin composition (I) or (II) of the present invention.

The heat-curable resin composition (I) or (II) of the present invention can be produced by uniformly mixing the above-described components. The heat-curable resin composition of the present invention can be easily formed into a cured product by the same as a general known method. Examples of the cured product include molded cured products such as a laminate, a cast product, an adhesive layer, a coating film, a film, and the like.

Applications using the heat-curable resin composition (I) or (II) of the present invention include semiconductor encapsulating materials, resin compositions used for laminates and electronic circuit boards, and the like, resin casting materials, adhesives, interlayer insulating materials for build-up substrates, coating materials such as insulating coating, and the like. Among these various applications, the resin composition can be preferably used for semiconductor encapsulating materials.

In order to prepare the heat-curable resin composition (I) or (II) for a semiconductor encapsulating material, the components including a filler may be sufficiently mixed until the resultant mixture becomes uniform using an extruder, a kneader, a roll, or the like according to demand, producing a melt-mixing type heat-curable resin composition. In this case, silica is generally used as the filler, and the filler is preferably used at a filling rate of 30% to 95% by mass relative to 100 parts by mass of the heat-curable resin composition (I) or (II). In particular, the filling rate is preferably 70 parts by mass or more in order to improve flame retardancy, moisture resistance, and solder crack resistance and to decrease the coefficient of linear expansion, and 80 parts by mass or more in order to significantly enhance the effect. In order to mold a semiconductor package, there is a method in which the composition is molded by casting or using a transfer molding machine or injection molding machine and then heated at 50 to 200°C for 2 to 10 hours, thereby producing a semiconductor device as a molded product.

When the heat-curable resin composition (I) or (II) of the present invention is processed into a composition for a printed circuit boar, for example, a resin composition for a prepreg can be prepared. The heat-curable resin composition can be used without using a solvent depending on its viscosity, but a varnish of the resin composition for a prepreg is preferably prepared using an organic solvent. As the organic solvent, a polar solvent having a boiling point of 160°C or less, such as methyl ethyl ketone, acetone, dimethylformamide, or the like, is preferably used, and these solvents can be used alone or as a mixed solvent of two or more. Any desired reinforcement substrate, such as paper, a glass cloth, a glass nonwoven fabric, aramid paper, an aramid cloth, a glass mat, a glass roving cloth, or the like, is impregnated with the resultant varnish, and heated at a heating temperature according to the type of solvent used, preferably 50 to 170°C, to form a prepreg as a cured product. The mass ratio between the resin composition and the reinforcement substrate used is not particularly limited but is preferably adjusted so that the resin content in the prepreg is 20 to 60% by mass. When a copper-clad lamination is produced using the heat-curable resin composition, the prepregs formed as described above are stacked by a usual method, and a copper foil is appropriately laminated thereon and heat-pressure bonded at 170 to 250°C for 10 minutes to 3 hours under a pressure of 1 to 10 MPa, thereby producing the copper-clad lamination.

When the heat-curable resin composition (I) or (II) of the present invention is used as a resist ink, an example of a usable method is one in which a resist ink composition is prepared by adding a cationic polymerization catalyst as a curing agent for the heat-curable resin composition (II) and further a pigment, talc, and filler, applied on a printed board by a screen printing method, and then cured to form a resist ink cured product.

When the heat-curable resin composition (I) or (II) of the present invention is used as conductive paste, examples of a usable method include a method of preparing a composition for an anisotropic conductive film by dispersing conductive fine particles in the heat-curable resin composition, and a method of preparing a circuit-connecting paste resin composition or an anisotropic conductive adhesive which is liquid at room temperature.

As a method for producing an interlayer insulating material for a build-up board from the heat-curable resin composition (I) or (II) of the present invention, for example, the heat-curable resin composition appropriately containing rubber and filler is applied to a circuit board having a circuit formed thereon by a spray coating method, a curtain coating method, or the like, and then cured. Then, if required, predetermined through holes are formed, and then a surface is treated with a coarsening agent, washed with hot water to form projections and depressions, and then plated with a metal such as copper. As the plating method, electroless plating and electrolytic plating are preferred, and an oxidizer, an alkali, and an organic solvent can be used as the coarsening agent. Such an operation is successively repeated according to demand to alternately build up a resin insulating layer and a conductor layer of a predetermined circuit pattern, thereby producing a build-up board. However, the through holes are formed after the outermost resin insulating layer is formed. Also, a build-up substrate can be formed by pressure-bonding a copper foil with a resin, which is formed by semi-curing the resin composition on the copper foil, under heating at 170 to 250°C on the circuit board having a circuit formed thereon, without the steps of forming a coarsened surface and of plating.

A method for producing a cured product of the present invention may be based on a general method for curing an epoxy resin composition. For example, a heating temperature condition may be appropriately selected according to the type of the curing agent combined and use thereof, but the composition prepared by the above-described method may be heated in the temperature range of about 20°C to about 250°C. In addition, a general method for epoxy resin compositions can be used as a molding method with no need for particular conditions for the heat-curable resin composition (I) or (II) of the present invention.

Therefore, according to the present invention, an environmentally-safe epoxy resin material capable of exhibiting a high degree of flame retardancy can be produced without using a halogen-based flame retardant. In addition, a higher operation speed of a high-frequency device can be realized by the excellent dielectric characteristics. Further, the phenol resin (B) or the epoxy resin (A') can be easily efficiently produced by the production method of the present invention, and molecular design can be realized according to the level of the above-described intended performance.

### [EXAMPLES]

Next, the present invention is described in further detail with reference to examples and comparative examples, and "parts" and "%" below are on a mass basis unless otherwise specified. In addition, melt viscosity at 150°C, GPC, and NMR, and MS spectra were measured under conditions described below.
1) Melt viscosity at 150°C: according to ASTM D4287
2) Softening point measuring method: according to JIS K7234
3) GPC:
   Apparatus: HLC-8220 GPC manufactured by Tosoh Corporation
   Column: TSK-GEL G2000HXL + G2000HXL + G3000HXL + G4000HXL manufactured by Tosoh Corporation
   Solvent: tetrahydrofuran
   Flow rate: 1 ml/min
   Detector: RI
4) NMR: NMR GSX270 manufactured by JEOL, Ltd.
5) MS: double focusing mass spectrometer AX505H (FD505H) manufactured by JEOL, Ltd.

### EXAMPLE 1 [Synthesis of phenol resin (A-1)]

In a flask provided with a thermometer, a cooling tube, a fractionating column, a nitrogen gas inlet tube, and a stirrer, 103.0 g of phenol novolac resin ("M-70G" manufactured by Showa Highpolymer Co., Ltd., softening point 70°C, hydroxyl equivalent 103 g/eq) represented by a structural formula below and 103.0 g of methyl isobutyl ketone were charged under nitrogen gas purging and then heated to 115°C.

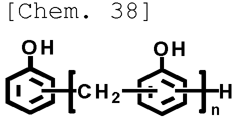

After heating, a mixture containing 88.8 g of methyl isobutyl ketone and 88.8 g (0.50 mol) of 1-chloromethylnaphthalene was added dropwise at 115°C over 2 hours. After the completion of addition, reaction was performed at 120°C for 1 hour and further at 150°C for 3 hours to produce 161 g of phenol resin (A-1). The resultant phenol resin had a softening point of 105°C (B & R method), a melt viscosity of 16.1 dPa·s (measurement method: ICI viscometer method, measurement temperature: 150°C), and a hydroxyl equivalent of 173 g/eq.

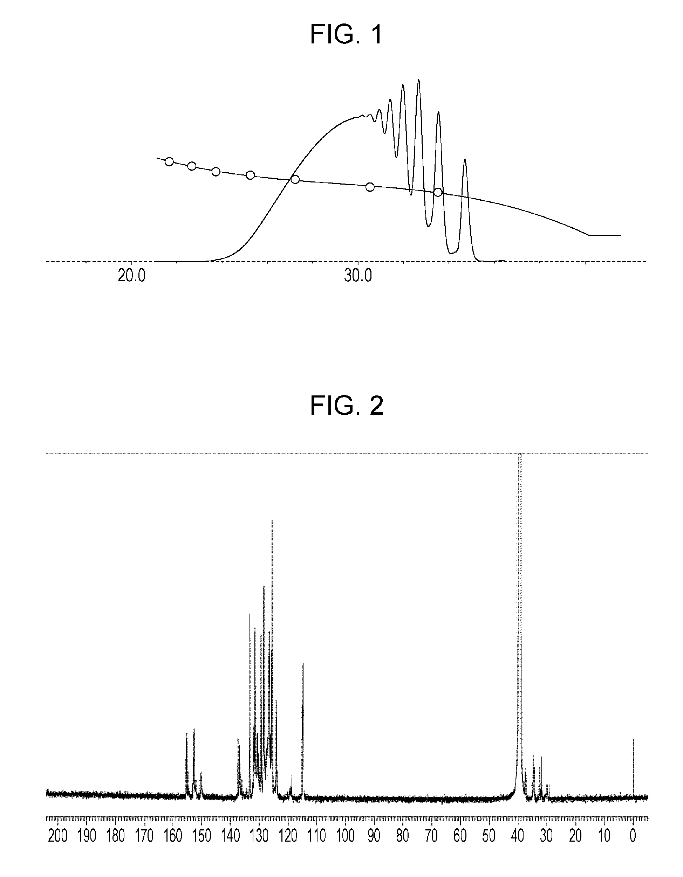

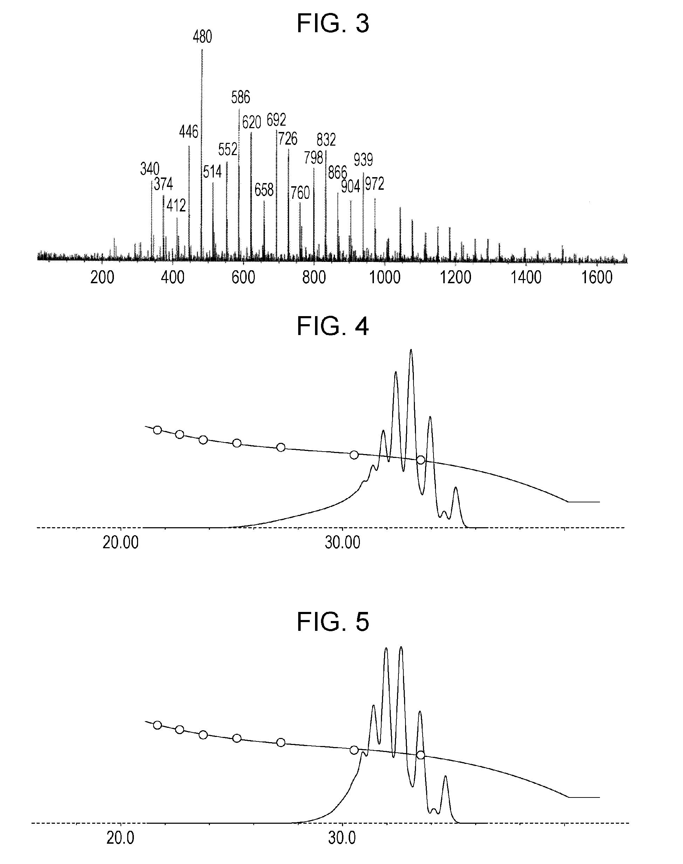

Fig. 1 shows a GPC chart of the phenol resin (A-1), Fig. 2 shows a ¹³C-NMR chart, and Fig. 3 shows a MS spectrum. The presence of a methylnaphthyl group corresponding to the general formula (I) was confirmed by the analysis. In addition, the ratio of the total number of methylnaphthyl groups was 50 relative to the total number of 100 of phenolic hydroxyl group-containing aromatic skeletons.

### EXAMPLE 2 [Synthesis of phenol resin (A-2)]

In a flask provided with a thermometer, a cooling tube, a fractionating column, a nitrogen gas inlet tube, and a stirrer, 75.8 g (0.76 mol) of bisphenol F ("DIC-BPF" manufactured by DIC Corporation), 25.3 g (hydroxyl group: 0.24 equivalents) of phenol novolac resin ("TD-2131" manufactured by DIC Corporation, softening point: 80°C, hydroxyl equivalent: 104 g/eq), and 101.1 g of methyl isobutyl ketone were charged under nitrogen gas purging and then heated to 115°C. After heating, a mixture containing 99.6 g of methyl isobutyl ketone and 99.6 g (0.56 mol) of 1-chloromethyl naphthalene was added dropwise at 115°C over 2 hours. The same subsequent operation as in Example 1 was performed to produce phenol resin (A-2). The resultant phenol resin had a softening point of 75°C (B & R method), a melt viscosity of 0.7 dPa·s (measurement method: ICI viscometer method, measurement temperature: 150°C), and a hydroxyl equivalent of 180 g/eq.
Fig. 4 shows a GPC chart of the phenol resin (A-2). In addition, the ratio of the total number of methylnaphthyl groups was 56 relative to the total number of 100 of phenolic hydroxyl group-containing aromatic skeletons.

### EXAMPLE 3 [Synthesis of phenol resin (A-3)]

In a flask provided with a thermometer, a cooling tube, a fractionating column, a nitrogen gas inlet tube, and a stirrer, 100.0 g (1.00 mol) of bisphenol F (manufactured by DIC Corporation, purity 99%) and 100.0 g of methyl isobutyl ketone were charged under nitrogen gas purging and then heated to 115°C. After heating, a mixture containing 126.1 g of methyl isobutyl ketone and 126.1 g (0.71 mol) of 1-chloromethylnaphthalene was added dropwise at 115°C over 2 hours. The same subsequent operation as in Example 1 was performed to produce phenol resin (A-3). The resultant phenol resin had a softening point of 72°C (B & R method), a melt viscosity of 0.5 dPa·s (measurement method: ICI viscometer method, measurement temperature: 150°C), and a hydroxyl equivalent of 200 g/eq. Fig. 5 shows a GPC chart of the phenol resin (A-3). In addition, the ratio of the total number of methylnaphthyl groups was 71 relative to the total number of 100 of phenolic hydroxyl group-containing aromatic skeletons.

### EXAMPLE 4 [Synthesis of phenol resin (A-4)]

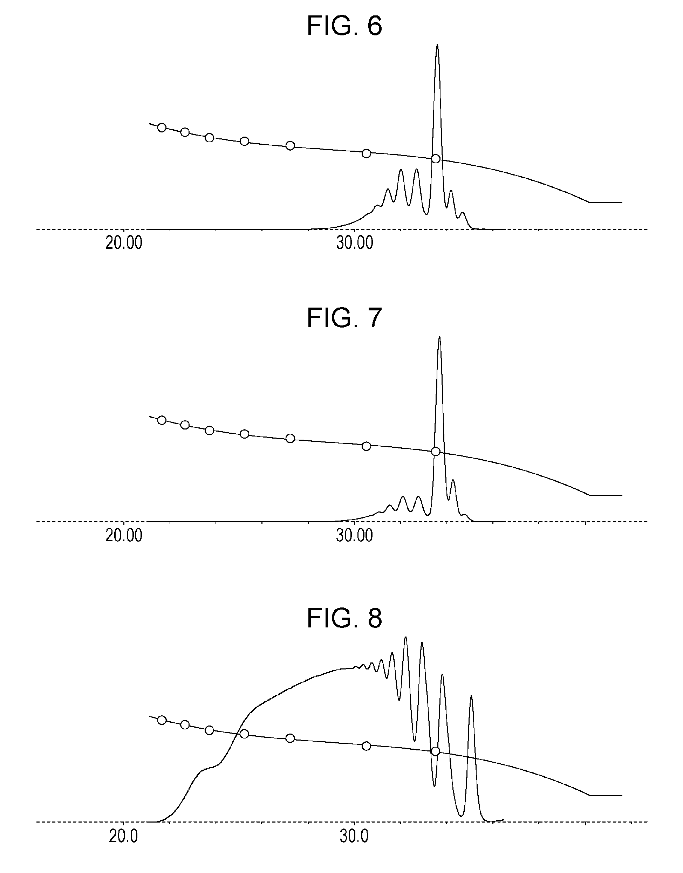

In a flask provided with a thermometer, a nitrogen gas inlet tube, and a stirrer, 59.0 g of the phenol resin (A-3) produced in Example 3 and 41.0 g of bisphenol F (manufactured by DIC Corporation, purity 99.0%) were charged under nitrogen gas purging and then mixed by over-heating at 120°C for 1 hour to produce phenol resin (A-4). The resultant phenol resin had a softening point of 57°C (B & R method), a melt viscosity of 0.2 dPa·s (measurement method: ICI viscometer method, measurement temperature: 150°C), and a hydroxyl equivalent of 142 g/eq. Fig. 6 shows a GPC chart of the phenol resin. In addition, the ratio of the total number of methylnaphthyl groups was 30 relative to the total number of 100 of phenolic hydroxyl group-containing aromatic skeletons.

### EXAMPLE 5 [Synthesis of phenol resin (A-5)]

In a flask provided with a thermometer, a cooling tube, a fractionating column, a nitrogen gas inlet tube, and a stirrer, 35.0 g of the phenol resin (A-3) produced in Example 3 and 65.0 g of bisphenol F (manufactured by DIC Corporation, purity 99.0%) were charged under nitrogen gas purging and then mixed by over-heating at 120°C for 1 hour to produce phenol resin (A-5). The resultant phenol resin had a softening point of 52°C (B & R method), a melt viscosity of 0.1 dPa·s (measurement method: ICI viscometer method, measurement temperature: 150°C), and a hydroxyl equivalent of 121 g/eq. Fig. 7 shows a GPC chart of the phenol resin (A-5). In addition, the ratio of the total number of methylnaphthyl groups was 15 relative to the total number of 100 of phenolic hydroxyl group-containing aromatic skeletons.

### COMPARATIVE EXAMPLE 1 [Synthesis of phenol resin (A-6): phenol resin described in Patent Literature 1]

In a flask provided with a thermometer, a cooling tube, a fractionating column, a nitrogen gas inlet tube, and a stirrer, 208 g of phenol novolac resin having a softening point 86°C and 0.5 g of p-toluenesulfonic acid were charged under nitrogen gas purging and then heated to 140°C. Then, 136 g (1 mol) of p-methylbenzyl methyl ether was added dropwise over 5 hours. During reaction, the produced methanol was distilled off to the outside of the system, and the reaction was terminated after aging at the same temperature for 5 hours. Then, gas was removed under reduced pressure with an aspirator to produce a phenol resin. The resultant phenol resin A-6 had a softening point of 91°C (B & R method), a melt viscosity of 3.1 dPa·s (measurement method: ICI viscometer method, measurement temperature: 150°C), and a hydroxyl equivalent of 174 g/eq.

### COMPARATIVE EXAMPLE 2 [Synthesis of phenol resin (A-7): phenol resin described in Patent Literature 2]

In a flask provided with a thermometer, a cooling tube, a fractionating column, a nitrogen gas inlet tube, and a stirrer, 192 g of 1,6-naphthalenediol, 81 g of dichloromethyl naphthalene (95.6% of 1,5-dichloromethyl compound, 3.0% of other dichloromethyl compounds, 1.4% of monochloromethyl compound), and 550 g of toluene were charged under nitrogen gas purging and then slowly heated under stirring to form a solution, directly followed by reaction for 2 hours under reflux at about 116°C. Then, the temperature was increased to 180°C while toluene was distilled off, directly followed by reaction for 1 hour. After the reaction, the solvent was removed by distillation under reduced pressure to produce a phenol resin. The resultant phenol resin A-7 had a hydroxyl equivalent of 114 g/eq, a softening point of 102°C (B & R method), and a melt viscosity of 20.1 dPa·s (measurement method: ICI viscometer method, measurement temperature: 150°C).

### EXAMPLE 6 [Synthesis of epoxy resin (E-1)]

In a flask provided with a thermometer, a dropping funnel, a cooling tube, and a stirrer, 173 g (hydroxyl group: 1 equivalent) of the phenol resin (A-1) produced in Example 1, 463 g (5.0 mol) of epichlorohydrin, 139 g of n-butanol, and 2 g of tetraethylbenzylammonium chloride were charged under nitrogen gas purging to prepare a solution. After the resultant solution was heated to 65°C, the pressure was reduced to azeotropic pressure, and 90 g (1.1 mol) of a 49% aqueous sodium hydroxide solution was added dropwise over 5 hours. Then, stirring was continued for 0.5 hour under the same conditions. During reaction under stirring, the azeotropic distillate was separated with a Dean and Stark trap, and the water layer was removed, while the oil layer was returned to the reaction system. Then, unreacted epichlorohydrin was removed by distillation under reduced pressure. The resultant crude epoxy resin was dissolved by adding 590 g of methyl isobutyl ketone and 177 g of n-butanol. Further, 10 g of a 10% aqueous sodium hydroxide solution was added to the solution, followed by reaction at 80°C for 2 hours. Then, water washing was repeated 3 times with 150 g of water each until the pH of the washing solution became neutral. Next, the reaction system was azeotropically dehydrated, and after microfiltration, the solvent was distilled off under reduced pressure to produce 218 g of epoxy resin (E-1). The resultant epoxy resin had a softening point of 83°C (B & R method), a melt viscosity of 5.1 dPa·s (measurement method: ICI viscometer method, measurement temperature: 150°C), and an epoxy equivalent of 260 g/eq.

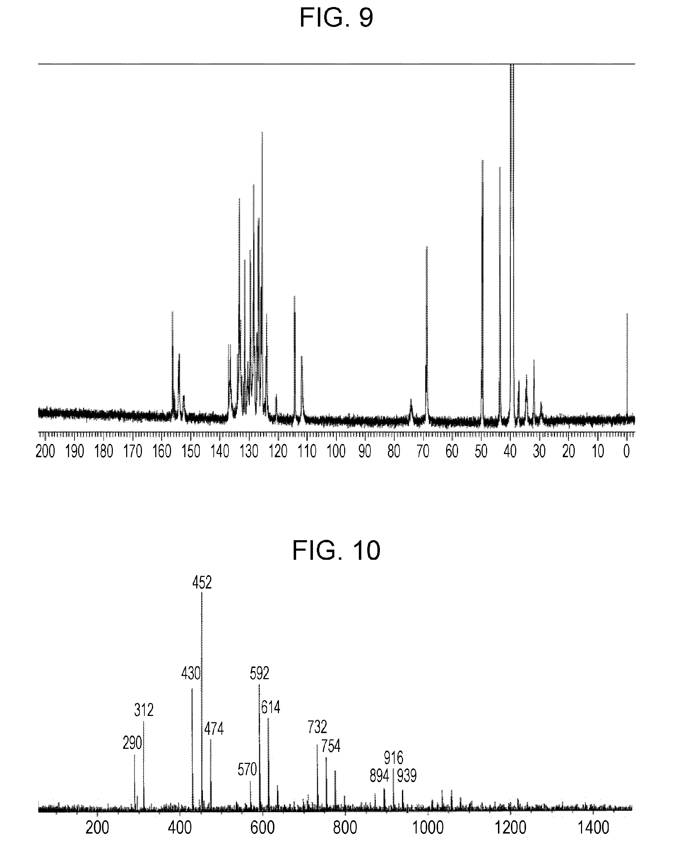

Fig. 8 shows a GPC chart of the epoxy resin (E-1), Fig. 9 shows a ¹³C-NMR chart, and Fig. 10 shows a MS spectrum. The presence of a methylnaphthyl group corresponding to the general formula (I) was confirmed by the analysis. In addition, the ratio of the total number of methylnaphthyl groups was 50 relative to the total number of 100 of glycidyl group-containing aromatic hydrocarbon groups.

### EXAMPLE 7 [Synthesis of epoxy resin (E-2)]

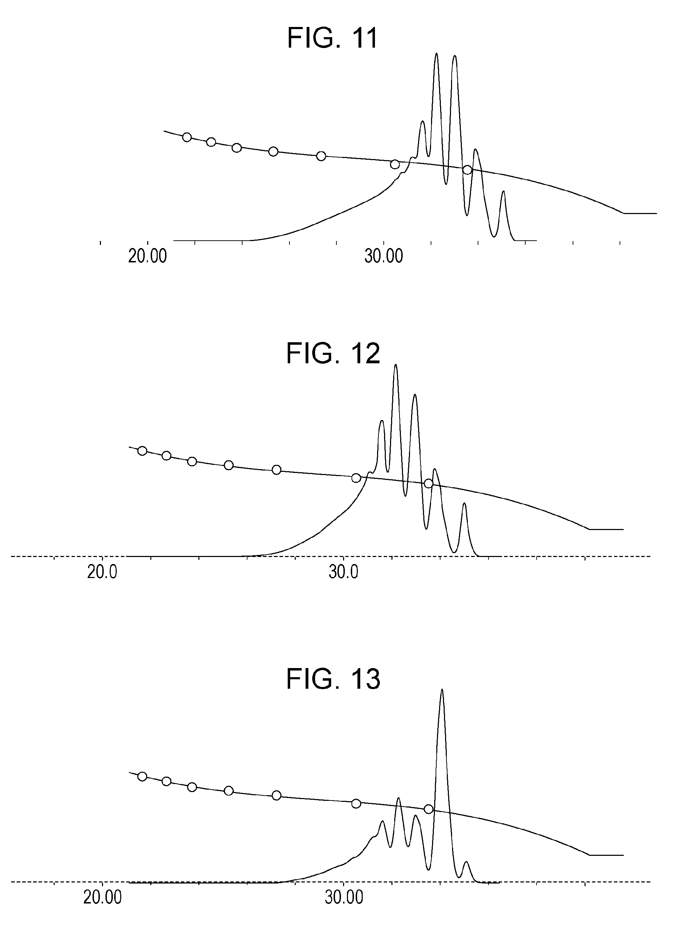

Epoxidation reaction was performed by the same method as in Example 6 except that the phenol resin (A-1) used in Example 6 was changed to 180 g (hydroxyl group: 1 equivalent) of the phenol resin (A-2) produced in Example 2, thereby producing epoxy resin (E-2). The resultant epoxy resin had a softening point of 56°C (B & R method), a melt viscosity of 0.5 dPa·s (measurement method: ICI viscometer method, measurement temperature: 150°C), and an epoxy equivalent of 268 g/eq. Fig. 11 shows a GPC chart of the epoxy resin (E-2). In addition, the ratio of the total number of methylnaphthyl groups was 56 relative to the total number of 100 of glycidyl group-containing aromatic hydrocarbon groups.

### EXAMPLE 8 [Synthesis of epoxy resin (E-3)]

Epoxidation reaction was performed by the same method as in Example 6 except that the phenol resin (A-1) used in Example 6 was changed to 200 g (hydroxyl group: 1 equivalent) of the phenol resin (A-3) produced in Example 3, thereby producing epoxy resin (E-3). The resultant epoxy resin had a softening point of 56°C (B & R method), a melt viscosity of 0.4 dPa·s (measurement method: ICI viscometer method, measurement temperature: 150°C), and an epoxy equivalent of 291 g/eq. Fig. 12 shows a GPC chart of the epoxy resin (E-3). In addition, the ratio of the total number of methylnaphthyl groups was 71 relative to the total number of 100 of glycidyl group-containing aromatic hydrocarbon groups.

### EXAMPLE 9 [Synthesis of epoxy resin (E-4)]

Epoxidation reaction was performed by the same method as in Example 6 except that the phenol resin (A-1) used in Example 6 was changed to 142 g (hydroxyl group: 1 equivalent) of the phenol resin (A-4) produced in Example 4, thereby producing epoxy resin (E-4). The resultant epoxy resin had a melt viscosity of 0.1 dPa·s (measurement method: ICI viscometer method, measurement temperature: 150°C) and an epoxy equivalent of 225 g/eq. Fig. 13 shows a GPC chart of the epoxy resin (E-4). In addition, the ratio of the total number of methylnaphthyl groups was 30 relative to the total number of 100 of glycidyl group-containing aromatic hydrocarbon groups.

### EXAMPLE 10 [Synthesis of epoxy resin (E-5)]

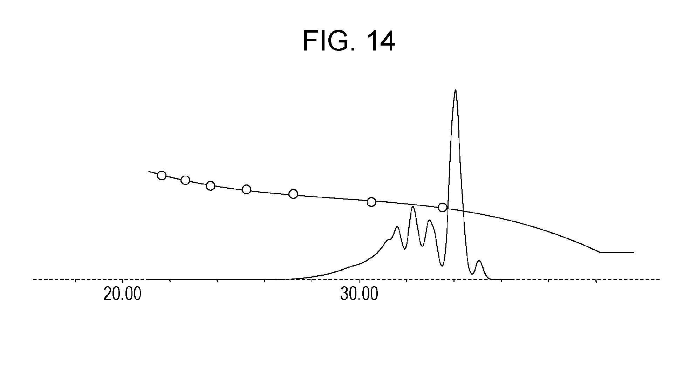

Epoxidation reaction was performed by the same method as in Example 6 except that the phenol resin (A-1) used in Example 6 was changed to 121 g (hydroxyl group: 1 equivalent) of the phenol resin (A-5) produced in Example 5, thereby producing epoxy resin (E-5). The resultant epoxy resin had an epoxy equivalent of 201 g/eq. Fig. 14 shows a GPC chart of the epoxy resin (E-5). In addition, the ratio of the total number of methylnaphthyl groups was 15 relative to the total number of 100 of glycidyl group-containing aromatic hydrocarbon groups.

### COMPARATIVE EXAMPLE 3 [Synthesis of epoxy resin (E-6): phenol resin described in Patent Literature 1]

In a flask provided with a thermometer, a cooling tube, a fractionating column, a nitrogen gas inlet tube, and a stirrer, 152 g of the phenol resin (A-3) produced in Comparative Example 1 and 555 g (6 mol) of epichlorohydrin were placed under purging with nitrogen gas and heated to 115°C. Then, 105 g (1.05 mol) of a 40% aqueous sodium hydroxide solution was added dropwise to the resultant mixture over 4 hours. During the addition, the reaction temperature was kept at 100°C or more, and the azeotropically distilled epichlorohydrin was returned to the reaction system through a Dean and Stark water separator while water was removed out of the system. After the addition of the aqueous sodium hydroxide solution, the time when water was no longer distilled was regarded as the end of the reaction. After the completion of the reaction, byproducts such as an inorganic salt etc. were filtered off, and excess epichlorohydrin was distilled off from the filtrate under reduced pressure to produce epoxy resin (E-6). The resultant epoxy resin had a softening point of 78°C (B & R method), a melt viscosity of 2.3 dPa·s (measurement method: ICI viscometer method, measurement temperature: 150°C), and an epoxy equivalent of 251 g/eq.

### COMPARATIVE EXAMPLE 4 [Synthesis of epoxy resin (E-7): phenol resin described in Patent Literature 2]

In a flask provided with a thermometer, a cooling tube, a fractionating column, a nitrogen gas inlet tube, and a stirrer, 100 g of the phenol resin (A-4) produced in Comparative Example 2, 812.1 g of epichlorohydrin, and 162.4 g of diglyme were charged under nitrogen gas purging, and 71 g of a 48% aqueous sodium hydroxide solution was added dropwise to the resultant mixture at 60°C over 4 hours under reduced pressure (about 100 mmHg). During the addition, the produced water was removed out of the system by azeotropy with epichlorohydrin while the azeotropically distilled epichlorohydrin was returned to the reaction system. After the addition, the reaction was further continued for 1 hour. Then, epichlorohydrin and diglyme were distilled off under reduced pressure, the residue was dissolved in 348.1 g of methyl isobutyl ketone, and then the produced salt was removed by filtration. Then, 21 g of a 48% aqueous sodium hydroxide solution was added to the filtrate, followed by reaction at 80°C for 2 hours. After the reaction, filtration and water-washing were performed, and then methyl isobutyl ketone as the solvent was distilled off under reduced pressure to produce epoxy resin (E-7). The resultant epoxy resin had a softening point of 62°C (B & R method), a melt viscosity of 1.2 dPa·s (measurement method: ICI viscometer method, measurement temperature: 150°C), and an epoxy equivalent of 175 g/eq.

### SYNTHESIS EXAMPLE 1 [Synthesis of epoxy resin (E-8)]

In a flask provided with a thermometer, a cooling tube, a fractionating column, a nitrogen gas inlet tube, and a stirrer, 432.4 g (4.00 mol) of o-cresol, 158.2 g (1.00 mol) of 2-methoxynaphthalene, and 179.3 g (formaldehyde 2.45 mol) of a 41 mass% aqueous formaldehyde solution were charged, and 9.0 g of oxalic acid was added to the resultant mixture, followed by heating to 100°C and reaction at 100°C for 3 hours. Then, 73.2 g (formaldehyde 1.00 mol) of a 41 mass% aqueous formaldehyde solution was added dropwise to the mixture over 1 hour while water was collected by the fractionating column. After the completion of addition, the temperature was increased to 150°C over 1 hour, followed by further reaction at 150°C for 2 hours. After the completion of reaction, 1500 g of methyl isobutyl ketone was further added, and the mixture was transferred to a separating funnel and washed with water. After water-washing was performed until the washing water showed neutrality, unreacted o-cresol and 2-methoxynaphthalene and methyl isobutyl ketone were removed from an organic layer by heating under reduced pressure to produce a phenol resin. The resultant phenol resin had a hydroxyl equivalent of 164 g/eq.

Next, in a flask provided with a thermometer, a dropping funnel, a cooling tube, and a stirrer, 164 g (hydroxyl group: 1 equivalent) of the resultant phenol resin, 463 g (5.0 mol) of epichlorohydrin, 139 g of n-butanol, and 2 g of tetraethylbenzylammonium chloride were charged under nitrogen gas purging to prepare a solution. After the resultant solution was heated to 65°C, the pressure was reduced to azeotropic pressure, and 90 g (1.1 mol) of a 49% aqueous sodium hydroxide solution was added dropwise over 5 hours. Then, stirring was continued for 0.5 hour under the same conditions. During reaction under stirring, the azeotropic distillate was separated with a Dean and Stark trap, and the water layer was removed, while the oil layer was returned to the reaction system. Then, unreacted epichlorohydrin was removed by distillation under reduced pressure. The resultant crude epoxy resin was dissolved by adding 590 g of methyl isobutyl ketone and 177 g of n-butanol. Further, 10 g of a 10% aqueous sodium hydroxide solution was added to the solution, followed by reaction at 80°C for 2 hours. Then, water washing was repeated 3 times with 150 g of water until the pH of the washing solution became neutral. Next, the reaction system was azeotropically dehydrated, and after microfiltration, the solvent was distilled off under reduced pressure to produce epoxy resin (E-8). The resultant epoxy resin had a melt viscosity of 0.8 dPa·s (measurement method: ICI viscometer method, measurement temperature: 150°C) and an epoxy equivalent of 250 g/eq.

### EXAMPLES 11 to 21 and COMPARATIVE EXAMPLES 5 to 8

The epoxy resins used were the above-described (E-1) to (E-8), "YX-4000H" (tetramethylbiphenol epoxy resin, epoxy equivalent: 195 g/eq) manufactured by Japan Epoxy Resin Co., Ltd., "NC-3000" (biphenyl novolac epoxy resin, epoxy equivalent: 274 g/eq) manufactured by Nippon Kayaku Co., Ltd., "NC-2000L" (phenol aralkyl epoxy resin, epoxy equivalent: 236 g/eq) manufactured by Nippon Kayaku Co., Ltd., and "N-655-EXP-S" (ortho-cresol novolac epoxy resin, epoxy equivalent: 200 g/eq) manufactured by DIC Corporation. The phenol resins used were the above-described (A-1) to (A-7), "TD-2131" (phenol novolac resin, hydroxyl equivalent: 104 g/eq) manufactured by DIC Corporation, "XLC-3L" (phenol aralkyl resin, hydroxyl equivalent: 172 g/eq) manufactured by Mitsui Chemicals, Inc., and "MEH-7851SS" (biphenyl novolac resin, hydroxyl equivalent: 200 g/eq) manufactured by Meiwa Plastic Industries, Ltd. The curing accelerator used was triphenylphosphine (TPP), the flame retardants used were magnesium hydroxide ("Ecomag Z-10" manufactured by Air Water Inc.) and aluminum hydroxide ("CL-303" manufactured by Sumitomo Chemical Co., Ltd.), the inorganic filler used was spherical silica ("FB-560" manufactured by Denki Kagaku Kogyo K.K.), and the silane coupling agent used was γ-glycidoxytriethoxysilane ("KBM-403" manufactured by Shin-Etsu Chemical Co.,). Further, carnauba wax ("PEARL WAX No. 1-P" manufactured by Cerarica Noda Co., Ltd.) and carbon black were used. These components were mixed according to each of the compositions shown in Tables 1 and 2 and melt-kneaded with two rolls at a temperature of 90°C for 5 minutes, thereby preparing an intended composition. The resultant composition was ground and then molded into a disk shape of φ50 mm x 3 (t) mm or a rectangular shape of 12.7 mm width x 127 mm length x 1.6 mm thickness using a transfer molding machine for a time of 180 seconds at a pressure of 70 kg/cm², a ram speed of 5 cm/sec, and a temperature of 175°C. The molded product was further cured at 180°C for 5 hours. With respect to the physical properties of the cured product, a test piece was formed from the cured product of the transfer molding by a method described below, and heat resistance, a coefficient of linear expansion, adhesion, moisture resistance and solder resistance, and flame retardancy were measured by methods described below. The results are shown in Tables 1 and 2. A test piece for adhesion was formed by transfer-molding a rectangular shape of 12.7 mm width x 127 mm length x 1.6 mm thickness using a mold in which a copper foil (manufactured by Furukawa Circuit Foil Co., Ltd., thickness 35 µm, GTS-MP treated shine surface used as a bonded surface with the resin composition) was placed on one of the surfaces, and then further curing at 180°C for 5 hours.

### <Curability>

First, 0.15 g of each epoxy resin composition was placed on a cure plate (manufactured by Thermo Electric Co., Ltd.) heated at 175°C, and timing was started with a stop watch. A sample was uniformly stirred with a tip of a bar, and when the sample was cut into filaments and remained on the plate, the stop watch was stopped. The time taken until the sample was cut and remained on the plate was determined as a gel time.

### <Heat resistance>

Glass transition temperature: measured using a viscoelasticity measuring device (solid viscoelasticity measuring device "RSA II" manufactured by Rheometrics Co.), double cantilever method; frequency 1 Hz, heating rate 3°C/min).

### <Coefficient of linear expansion>

The cured product was formed into a test piece of about 5 mm in width and about 5 mm in length and subjected to compression-mode thermal mechanical analysis using a thermal mechanical analyzer (TMA: "SS-6100" measured by Seiko Instruments Co., Ltd.). At the second measurement (measurement load: 30 mN, heating rate: 3 °C/min (two times), measurement temperature range: -50°C to 250°C), a coefficient of linear expansion at 50°C was measured.

### <Adhesion>

The cured product was formed into a test piece of 10 mm in width and peel strength was measured at a speed of 50 mm/min.

### <Moisture resistance and solder resistance>

The disk-shaped test piece of φ50 mm x 3 (t) mm was subjected to moisture absorption treatment by being allowed to stand in an atmosphere of 85°C and 85% RH for 168 hours, and then immersed in a solder bath of 260°C for 10 seconds to examine the occurrence of a crack.
Good: No occurrence of crack
Poor: Occurrence of crack

### <Flame retardancy>

A combustion test was conducted using five evaluation test pieces of 12.7 mm in width, 127 mm in length, and 1.6 mm in thickness according to the UL-94 test method.
*1: Total flaming combustion time (second) of five test pieces
*2: Maximum flaming combustion time (second) at each time of flame application

**[Table 1]**

| | | | Example 11 | Example 12 | Example 13 | Example 14 | Example 15 | Example 16 | Example 17 | Example 18 | Example 19 | Example 20 | Example 21 |
|---|---|---|---|---|---|---|---|---|---|---|---|---|---|
| Epoxy resin | E-1 | | 74 | | | | | | | | | | |
| | E-2 | | | 80 | | | | | | 82 | | | |
| | E-3 | | | | 83 | | | | | | | | |
| | E-4 | | | | | 90 | | | | | | | |
| | E-5 | | | | | | 71 | | | | | | |
| | E-8 | | | | | | | 77 | | | | 40 | 42 |
| | NC-2000L | | | | | | | | | | 74 | | |
| | NC-3000 | | | | | | | | 76 | | | | |
| | YX-4000H | | | | | | | | | | | 40 | |
| | N-655-EXP-S | | | | | | | | | | | | 42 |
| Curing agent | A-1 | | | | | | | 54 | | | | | |
| | A-2 | | | | | | | | | 49 | 57 | | |
| | A-3 | | | | | | | | 55 | | | | |
| | A-4 | | | | | | | | | | | 52 | |
| | A-5 | | | | | | | | | | | | 46 |
| | MEH-7851SS | | 57 | | | | | | | | | | |
| | XLC-3L | | | 51 | 48 | | | | | | | | |
| | TD-2131 | | | | | 41 | 60 | | | | | | |
| Aluminum hydroxide | | | | | | | | | | | | | 50 |
| Magnesium hydroxide | | | | | | | | | | | | 50 | |
| TPP | | | 3 | 3 | 3 | 3 | 3 | 3 | 3 | 3 | 3 | 3 | 3 |
| Fused silica | | | 860 | 860 | 860 | 860 | 860 | 860 | 860 | 860 | 860 | 810 | 810 |
| Silane coupling agent | | | 2 | 2 | 2 | 2 | 2 | 2 | 2 | 2 | 2 | 2 | 2 |
| Carnauba wax | | | 1 | 1 | 1 | 1 | 1 | 1 | 1 | 1 | 1 | 1 | 1 |
| Carbon black | | | 3 | 3 | 3 | 3 | 3 | 3 | 3 | 3 | 3 | 3 | 3 |
| Curability sec | | | 27 | 25 | 34 | 33 | 32 | 41 | 44 | 31 | 32 | 48 | 44 |
| Thermal expansion coefficient (α1) ppm | | | 8.3 | 8.4 | 8.6 | 8.1 | 8.6 | 8.3 | 8.6 | 8.1 | 8.4 | 8.4 | 8.6 |
| Adhesion N/cm | | | 190 | 200 | 230 | 210 | 170 | 190 | 230 | 240 | 200 | 200 | 180 |
| Moisture resistance and solder resistance | | | Good | Good | Good | Good | Good | Good | Good | Good | Good | Good | Good |
| Flame retardancy Class | | | V-0 | V-0 | V-0 | V-0 | V-0 | V-0 | V-0 | V-0 | V-0 | V-0 | V-0 |
| | ΣF^{*1} | sec | 13 | 22 | 12 | 38 | 46 | 39 | 38 | 11 | 27 | 40 | 43 |
| | Rmax^{*2} | sec | 4 | 6 | 3 | 8 | 9 | 6 | 7 | 3 | 6 | 7 | 9 |

**[Table 2]**

| | | | Comparative Example 5 | Comparative Example 6 | Comparative Example 7 | Comparative Example 8 |
|---|---|---|---|---|---|---|
| Epoxy resin | E-6 (described in PTL 1) | | | 78 | | |
| | E-7 (described in PTL 2) | | | | 66 | |
| | E-8 | | 77 | | | |
| | N-655-EXP-S | | | | | 86 |
| Curing agent | A-1 | | | | | |
| | A-2 | | | | | |
| | A-3 | | | | | |
| | A-4 | | | | | |
| | A-5 | | | | | |
| | A-6 (described in PTL 1) | | 54 | | | |
| | MEH-7851SS | | | | | |
| | XLC-3L | | | 53 | 65 | |
| | TD-2131 | | | | | 45 |
| TPP | | | 3 | 3 | 3 | 3 |
| Fused silica | | | 860 | 860 | 860 | 860 |
| Silane coupling agent | | | 2 | 2 | 2 | 2 |
| Carnauba wax | | | 1 | 1 | 1 | 1 |
| Carbon black | | | 3 | 3 | 3 | 3 |
| Curability | | sec | 35 | 34 | 18 | 31 |
| Thermal expansion coefficient (α1) | | ppm | 9.5 | 9.0 | 8.6 | 9.0 |
| Adhesion | | N/cm | 150 | 160 | 80 | 90 |
| Moisture resistance and solder resistance | | - | Poor | Poor | Poor | Poor |
| Flame retardancy Class | | | Burning | Burning | V-1 | Burning |
| ΣF^{*1} | sec | | - | - | 78 | - |
| Rmax^{*2} | sec | | - | - | 22 | - |

In the tables, abbreviations are as follows.
NC-2000L: phenol aralkyl epoxy resin ("NC-2000L" manufactured by Nippon Kayaku Co., Ltd., epoxy equivalent: 236 g/eq)
NC-3000: biphenyl novolac epoxy resin ("NC-3000" manufactured by Nippon Kayaku Co., Ltd., epoxy equivalent: 274 g/eq)
YX-4000H: tetramethylbiphenol epoxy resin ("YX-4000H" manufactured by Japan Epoxy Resin Co., Ltd., epoxy equivalent: 195 g/eq)
N-655-EXP-S: cresol novolac epoxy resin ("Epiclon N-655-EXP-S", epoxy equivalent: 200 g/eq)
MEH-7851SS: biphenyl novolac resin ("MEH-7851SS" manufactured by Meiwa Plastic Industries, Ltd., hydroxyl equivalent: 200 g/eq)
XLC-3L: phenol aralkyl resin ("XLC-3L" manufactured by Mitsui Chemicals, Inc., hydroxyl equivalent: 172 g/eq)
TD-2131: phenol novolac phenol resin ("TD-2131" manufactured by DIC Corporation, hydroxyl equivalent: 104 g/eq)
TPP: triphenylphosphine

## Claims

1. A heat-curable resin composition comprising, as essential components, an epoxy resin (A) and a phenol resin (B), wherein the phenol resin (B) has a phenol resin structure having, as a basic skeleton, a structure in which a plurality of phenolic hydroxyl group-containing aromatic skeletons (ph) are bonded to each other through an alkylidene group or a methylene group having an aromatic hydrocarbon structure, and an aromatic nucleus of the phenol resin structure has a naphthylmethyl group or an anthrylmethyl group.

2. The heat-curable resin composition according to Claim 1, wherein the phenol resin (B) contains the naphthylmethyl groups or anthrylmethyl groups at a ratio of a total number of 10 to 200 relative to a total number of 100 of the phenolic hydroxyl group-containing aromatic skeletons (ph).

3. The heat-curable resin composition according to Claim 1, wherein the phenol resin (B) has a melt viscosity at 150°C of 0.1 to 100 dPa·s measured with an ICI viscometer.

4. A semiconductor encapsulating material comprising, in addition to the epoxy resin (A) and the phenol resin (B) according to Claim 1, 2, or 3, an inorganic filler at a ratio of 70% to 95% by mass in the composition.

5. A cured product produced by a curing reaction of the heat-curable resin composition according to any one of Claims 1 to 3.

6. A phenol resin having a phenol resin structure having, as a basic skeleton, a structure in which a plurality of phenolic hydroxyl group-containing aromatic skeletons (ph) are bonded to each other through an alkylidene group or a methylene group having an aromatic hydrocarbon structure, and an aromatic nucleus of the phenol resin structure has a naphthylmethyl group or an anthrylmethyl group.

7. The phenol resin according to Claim 6, wherein the ratio of the total number of the naphthylmethyl groups or anthrylmethyl groups is 10 to 200 relative to the total number of 100 of the phenolic hydroxyl group-containing aromatic skeletons (ph).

8. The phenol resin according to Claim 6 or 7, wherein the melt viscosity at 150°C measured with an ICI viscometer is 0.1 to 100 dPa·s.

9. A heat-curable resin composition comprising, as essential components, an epoxy resin (A') and a curing agent (B'), wherein the epoxy resin (A') has an epoxy resin structure having, as a basic skeleton, a structure in which a plurality of glycidyloxy group-containing aromatic skeletons (ep) are bonded to each other through an alkylidene group or a methylene group having an aromatic hydrocarbon structure, and an aromatic nucleus of the epoxy resin structure has a naphthylmethyl group or an anthrylmethyl group.

10. The heat-curable resin composition according to Claim 9, wherein the epoxy resin (A') contains the naphthylmethyl groups or anthrylmethyl groups at a ratio of a total number of 10 to 200 relative to a total number of 100 of the glycidyloxy group-containing aromatic skeletons (ph).

11. The heat-curable resin composition according to Claim 9 or 10, wherein the epoxy resin (A') has a melt viscosity at 150°C of 0.1 to 100 dPa·s measured with an ICI viscometer.

12. A semiconductor encapsulating material comprising, in addition to the epoxy resin (A') and the curing agent (B'), an inorganic filler at a ratio of 70% to 95% by mass in the composition.

13. A cured product produced by a curing reaction of the heat-curable resin composition according to any one of Claims 9 and 10.

14. An epoxy resin having an epoxy resin structure having, as a basic skeleton, a structure in which a plurality of glycidyloxy group-containing aromatic skeletons (ep) are bonded to each other through an alkylidene group or a methylene group having an aromatic hydrocarbon structure, and an aromatic nucleus of the epoxy resin structure has a naphthylmethyl group or an anthrylmethyl group.

15. The epoxy resin according to Claim 14, wherein the ratio of the total number of the naphthylmethyl groups or anthrylmethyl groups is 10 to 200 relative to the total number of 100 of the glycidyloxy group-containing aromatic skeletons (ph).

16. The epoxy resin according to Claim 14 or 15, wherein the melt viscosity of the epoxy resin at 150°C measured with an ICI viscometer is 0.1 to 100 dPa·s.
